(19) Europäisches Patentamt
European Patent Office
Office européen des brevets

(11) **EP 3 420 345 B1**

(12) **EUROPÄISCHE PATENTSCHRIFT**

(45) Veröffentlichungstag und Bekanntmachung des Hinweises auf die Patenterteilung:
**21.06.2023 Patentblatt 2023/25**

(21) Anmeldenummer: **17707158.6**

(22) Anmeldetag: **25.01.2017**

(51) Internationale Patentklassifikation (IPC):
*G01N 21/71* (2006.01)   *G01N 21/73* (2006.01)
*G01J 3/443* (2006.01)   *H01J 37/32* (2006.01)

(52) Gemeinsame Patentklassifikation (CPC):
**G01N 21/73; G01J 3/443; G01N 21/71; H01J 37/32917**

(86) Internationale Anmeldenummer:
**PCT/DE2017/000003**

(87) Internationale Veröffentlichungsnummer:
**WO 2017/144034 (31.08.2017 Gazette 2017/35)**

(54) **VERFAHREN ZUR BESTIMMUNG DER OBERFLÄCHENEIGENSCHAFTEN VON TARGETS**

METHOD FOR DETERMINING THE SURFACE CHARACTERISTICS OF TARGETS

PROCÉDÉ DE DÉTERMINATION DES PROPRIÉTÉS DE SURFACE DE CIBLES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.02.2016 DE 102016002270**

(43) Veröffentlichungstag der Anmeldung:
**02.01.2019 Patentblatt 2019/01**

(73) Patentinhaber: **Forschungszentrum Jülich GmbH 52425 Jülich (DE)**

(72) Erfinder:
• **MARCHUK, Oleksandr 52355 Düren (DE)**
• **BRANDT, Christian 52066 Aachen (DE)**
• **POSPIESZCZYK, Albrecht 53127 Bonn (DE)**

(56) Entgegenhaltungen:
• **C Brandt ET AL: "Fast non-Maxwellian atoms in a linear magnetized plasma", 42nd EPS Conference on Plasma Physics, 2015, Seiten 1-4, XP055361557, Gefunden im Internet: URL:http://ocs.ciemat.es/EPS2015PAP/pdf/O3 .J 107.pdf [gefunden am 2017-04-04]**
• **M.R. GEMISIC ADAMOV ET AL: "Doppler spectroscopy of hydrogen and deuterium balmer alpha line in an abnormal glow discharge", IEEE TRANSACTIONS ON PLASMA SCIENCE., Bd. 31, Nr. 3, 2003, Seiten 444-454, XP055362214, US ISSN: 0093-3813, DOI: 10.1109/TPS.2003.811642**

**Beschreibung**

Die Erfindung betrifft ein Verfahren zur in situ Bestimmung der Oberflächeneigenschaften von leitfähigen Targets.

Stand der Technik

Technologische Plasmen werden zunehmend in der Industrie und in Forschungslaboratorien angewendet und dienen unter anderem zur Produktion von hochtechnologischen Produkten wie Mikrochips in der EUV-Lithographie, zur Reinigung von verschiedenen Oberflächen und Materialen in der Medizinphysik und zur Beschichtung von Spiegeln in der Produktion von optischen Elementen. Zu technologischen Plasmen zählen zum Beispiel Hohlkathodenentladungen, RF-Entladungen, Magnetronentladungen, Glimmentladungen und lineare Entladungsanordnungen. Eine sehr wichtige Rolle bei der Überwachung und Kontrolle von bestimmten Produktionsprozessen spielt das Reflektionsvermögen von metallischen, meistens spiegelnden Oberflächen.

Das Reflektionsvermögen von Oberflächen wird im Folgenden in zwei Themengebiete getrennt: die Reflektion von Teilchen (Atome) und die Reflektion von Licht (Photonen). Die Reflektion der Plasmateilchen an der Oberfläche ist ein unaufhaltsamer Vorgang, der aufgrund der Wechselwirkung zwischen den Plasma-Ionen und der Oberfläche stattfindet. Abhängig von den gewünschten technologischen Produktionsprozessen kann diese Wechselwirkung positive und negative Auswirkungen haben. So werden zum Beispiel bei der Produktion der Spiegel die Substrate (Fe, W, Mo) speziell beschichtet (Al, Au oder Ag). Die Beschichtung durch Plasmaverunreinigungen oder die Erosion des Substrats stellt dagegen negative, meistens unbeabsichtigte Wirkungen auf die Oberfläche dar. Die Eigenschaften der Teilchenreflektion, wie die Energie- und Winkelverteilung der reflektierten Plasmateilchen, kann Informationen über den Zustand der Oberfläche liefern, wie zum Beispiel die Art des Materials oder die Rauigkeit [1, 2]. Einen weiteren diagnostischen Zugang eröffnet das spektrale Reflektionsvermögen von optischen Metallspiegeln und spiegelnden Oberflächen [3]. Dieses kann genutzt werden um die Effizienz des technologischen Prozesses zu kontrollieren. So werden zum Beispiel verschiedene optische Systeme angewendet, um mit Kameras und speziellen Instrumenten (Spektrometern) die Produktionsprozesse zu quantifizieren und besser zu steuern. Ziemlich häufig werden dabei auch die Plasmaparameter bestimmt. Dazu zählen auch sehr komplexe optische Labyrinthe, die aus mehreren Spiegeln bestehen. Der wichtigste Grenzfall der spektralen Reflektion ist die spekulare Reflektion, also die Spiegelreflektion, oder eine rein diffuse Reflektion und ihre Polarisationseigenschaften [4]. Mit entsprechenden theoretischen Modellen können aufgrund der physikalischen Größen wie die Energie und die Winkelverteilung der Teilchen andere physikalische Parameter der Oberfläche, wie zum Beispiel die Rauigkeit, bestimmt werden.

Um quantifizierte Aussagen über den Verlauf des Prozesses zu erhalten, ist es notwendig, das Reflektionsvermögen der Oberfläche während des Prozesses ständig neu zu bestimmen [3]. Das größte Problem dabei stellt die Tatsache dar, dass das Material dafür üblicherweise aus dem Plasma entfernt werden und somit der Plasmabetrieb unterbrochen werden muss.

Simultane Messungen der Teilchen- und Lichtreflektion sind nur aufwendig in einem einzigen Laborexperiment zu vereinbaren, weil die Eigenschaften von Photonen und Atomen so verschieden sind. Aus diesem Grund verwendet man zur Bestimmung der Teilchenreflektions- und Lichtreflektionseigenschaften unterschiedliche Methoden. Es existiert bis heute keine Methode, die die Bestimmung beziehungsweise Messung beider Parameter ermöglicht, das heißt, die Reflektion von Teilchen und Photonen in situ im Plasma ohne zusätzliche Mittel näherungsweise zu messen.

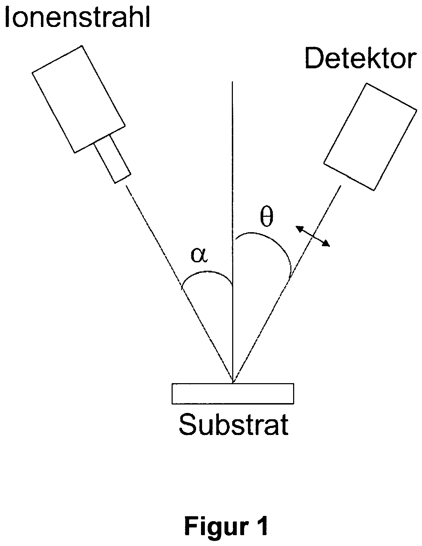

Zur Bestimmung der Energie- und Winkelverteilung von reflektierten Atomen an einer Oberfläche wird eine Ionen-Bestrahlung der Oberfläche entweder mit Laser-Induzierter-Fluoreszenz (LIF) oder mit einem Energie-Massen-Detektor kombiniert. Der Messaufbau ist schematisch in Figur 1 dargestellt.

Zunächst werden die auf die Oberfläche treffenden Ionen neutralisiert. Die neutralen Atome verlassen die Oberfläche mit einer kleineren Energie als die Ioneneinfallsenergie ($E_0$). Die Atome werden entsprechend einer bestimmten Energieverteilung $f(E<E_0)$ zurückgestreut. Die Beobachtung der Reflektion unter verschiedenen Winkeln liefert die Winkelverteilung der reflektierten Atome. Die theoretische Beschreibung des Teilchenreflektionsprozesses kann mit Hilfe von Monte-Carlo-Simulationen, wie zum Beispiel dem Code TRIM oder SRIM berechnet werden [5]. Generell findet man so eine gute Übereinstimmung mit den gemessenen Daten. An dieser Stelle gilt es nun darauf hinzuweisen, dass die Rauigkeit einer Oberfläche sowie deren eventuelle Beschichtung die Ergebnisse dieser Verteilung stark beeinflussen. Demzufolge stellen die Winkel- und Energieverteilung der gestreuten Teilchen während des Plasmabetriebs unersetzbare Messgrößen dar [3].

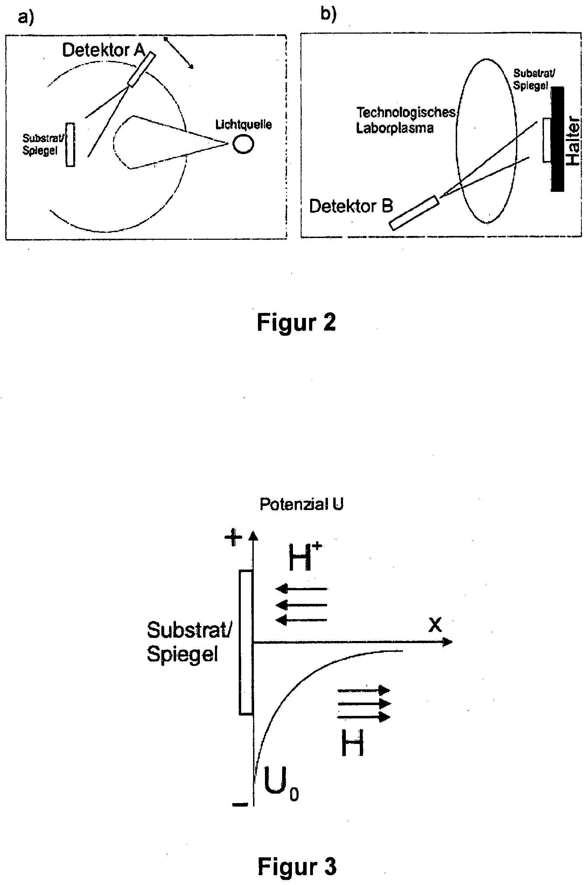

Im Fall von spiegelnden Oberflächen stellt sich nicht nur die Frage nach den reflektierten Teilchen sondern auch nach der spektralen beziehungsweise spekularen Reflektion des Lichtes. Um diese Frage beantworten zu können, steht hier eine große Anzahl von spektrophotometrischen Geräten zur Verfügung. Insgesamt stellt die Messung des Reflektionsvermögens von verschiedenen Materialen eine der wichtigsten Aufgaben der Spektrophotometrie dar [3]. Die Skizze in Figur 2(a) zeigt den wesentlichen Verlauf solcher Messungen, wobei sich die Details bei verschiedenen Geräten unterscheiden können [3].

Vor dem Platzieren im Plasma wird der Spiegel sorgfältig im Spiegellabor hinsichtlich des Reflektionsvermögens vermessen. Während eine absolut kalibrierte Lichtquelle den Spiegel beleuchtet, erfolgt die Messung der Reflektion unter den Winkeln, die später beim Produktionsprozess angewendet werden. Figur 2(b) zeigt wie der Spiegel später in der Plasmakammer platziert und das Plasma eingeschaltet wird. Die Überwachung des Produktionsprozesses erfolgt durch den Detektor B. Aufgrund des Kontaktes mit dem Plasma kann sich das Reflektionsvermögen mit der Zeit ändern. Durch die ständig stattfindenden Kollisionen der Plasmateilchen (oder durch die Teilchen von Verunreinigungen) mit der Oberfläche des Spiegels verschlechtert sich in den meisten Fällen dessen Reflektionsvermögen. Man ist aber nicht in der Lage, das Reflektionsvermögen in situ neu zu messen, weil der technologische Prozess dazu üblicherweise unterbrochen werden muss. Stattdessen muss der Spiegel aus dem Plasma entfernt und erneut im Labor getestet werden unter Wiederholung der in Figur 1 beschriebenen Schleife. Für gezielte Beschichtungsprozesse oder auch bei Auftreten eines Betriebsfehlers muss das Material wieder aus dem Plasma entfernt werden, um so das Reflektionsvermögen neu zu bestimmen.

Es gibt Anwendungen, bei denen das Öffnen der Plasmakammer und ein wiederholtes Messen des Reflektionsvermögens nach Figur 1 nicht möglich ist. Dazu zählen Prozesse in giftigen oder radioaktiven Umgebungen. Erneute Messungen des Reflektionsvermögens der Oberfläche von Teilchen und Photonen in solchen Umgebungen können aus praktischer Sicht nicht möglich oder aber nur mit hohem Kosten- und Zeitaufwand verbunden sein. Einige zukünftig geplante Großprojekte, wie zum Beispiel das Fusionsexperiment ITER oder der Experimentalreaktor DEMO, werden mit radioaktiv aktivierten Materialien umgehen müssen. Für die dann dem Plasma ausgesetzten Oberflächen sind die Folgen noch gravierender, weil Informationen über die Zustände der Oberflächen (Wände, Substrate und Spiegel) nicht genau vorhergesehen werden können.

Die Publikation [10] beschreibt Analysen zur Beschleunigung von Ionen im Vakuum und offenbart, wie blau- und rotverschobene Spektren, der sog. Doppler Effekt, zu Stande kommen. Dabei geht die [10] davon aus, dass die kinetische Energie (E) der Atome konstant ist.

## Aufgabe der Erfindung

Aufgabe der Erfindung ist die Bereitstellung eines Verfahrens zur in situ Bestimmung der Oberflächeneigenschaften von leitfähigen Targets, welches eine gleichzeitige Messung von Teilchen- und Lichtreflektion ermöglicht.

## Lösung der Aufgabe

Diese Aufgabe wird mit dem Verfahren des unabhängigen Anspruch 1 gelöst. Bevorzugte Ausführungsformen sind in den abhängigen Ansprüchen definiert.

## Beschreibung der Erfindung

Das erfindungsgemäße in situ Verfahren zur Bestimmung der Eigenschaften der Reflektion von Wasserstoff- oder Deuteriumatomen an der Oberfläche von elektrisch leitenden Materialien in Niederdruckplasmen ermöglicht die Bestimmung der Energie- und Winkelverteilung der an der Metalloberfläche reflektierten Atome. Im Fall von spiegelnden Oberflächen beziehungsweise von Spiegeln, ist es zusätzlich möglich, direkt das spektrale Reflektionsvermögen und Polarisationseigenschaften der Oberfläche zu messen. Mit den diagnostischen Zugängen zu diesen Messgrößen kann das Verfahren in zahlreichen Technologieprozessen sowie Laborexperimenten eingesetzt werden.

Der Kern der Erfindung umfasst ein Verfahren zur in situ Bestimmung der Reflektionseigenschaften von metallischen Oberflächen für Teilchen und Licht. Die vorgestellte Methode ermöglicht die Messung der Energie- und Winkelverteilung der an einer Metalloberfläche gestreuten Wasserstoff- oder Deuterium-Atome. Aus der Dopplerverschiebung der blau- und rotverschobenen Komponenten der induzierten Balmer-Linien kann direkt das spektrale (beziehungsweise spekulare) Reflektionsvermögen der Oberfläche gemessen werden. Das erfindungsgemäße Verfahren ist beispielsweise vorteilhaft für die Produktion von Spiegeln einsetzbar, für das Erzeugen von Beschichtungen und für die Analyse der Eigenschaften von Oberflächen. Ebenso kann es einen unterbrechungsfreien Zugang zu den genannten Messgrößen für die Untersuchung von Oberflächen in gefährlichen, wie zum Beispiel giftigen oder radioaktiven Umgebungen ermöglichen. Eines der möglichen Felder für zukünftige Anwendungen ist zum Beispiel die radioaktive Plasmaumgebung, wenn die optischen Komponenten besonders schwer zugänglich sind.

Vorteilhaft lassen sich mit diesem Verfahren in situ die Oberflächeneigenschaften, insbesondere die Masse $m_2$ der Atome der Oberfläche bei gleichzeitiger Messung der reflektierten Teilchen und des reflektierten Lichtes bestimmen. Insbesondere lässt sich die Verteilung der Energie der reflektierten Teilchen und der Intensität des reflektierten Lichtes gleichzeitig mit der Masse der Oberflächenatome in situ bestimmen. Die Größen $m_1$ und $m_2$ umfassen hier insbesondere jeweils die durchschnittliche Masse eines entsprechenden Atoms beziehungsweise die durchschnittliche mit dem Verfahren ermittelte Masse.

Wenn die Ionen in dem Niederdruckplasma positiv sind, nehmen sie bei dem Reflektionsprozess an der Oberfläche hinreichend viele Elektronen auf, wenn sie negativ geladen sind, geben sie entsprechend hinreichend viele Elektronen ab und werden so in elektrisch neutrale Atome umgewandelt. Die Oberfläche des Targets kann mit einer Stromquelle verbunden sein und auf diese Weise auch bei einem Ladungsaustausch mit den Ionen aus dem Niederdruckplasma auf einem gewünschten elektrischen Potential gehalten werden.

Unter der Durchführung der Bestimmung der Oberflächeneigenschaften in situ soll im Rahmen der Anmeldung verstanden werden, dass das Target sich während der Bestimmung im Vakuum befindet und dieses nicht verlässt.

Zur Umrechnung von Frequenz f und Energie E der Photonen elektromagnetischer Strahlung kann die bekannte Formel $E = hf$ mit dem Planckschen Wirkungsquantum $h = 4,135667662 \cdot 10^{-15}$ eV·s verwendet werden. Der Zusammenhang zwischen Frequenz eines Photons f und seiner Wellenzahl beziehungsweise Wellenlänge A wird bekanntermaßen durch die je nach Randbedingungen gültige Dispersionsrelation beschrieben. Alternativ kann die mit jeweils einer Frequenz korrespondierende Wellenlänge auch durch ein aus der Optik bekanntes Verfahren gemessen werden, zum Beispiel unter Verwendung des Beugungsmusters eines optischen Gitters. Näherungsweise kann die Relation für den freien Raum angenommen werden, also: $\lambda = c/f$, wobei c die Ausbreitungsgeschwindigkeit des Lichts bezeichnet.

Die Anzahl der Photonen kann durch Photonendetektoren gemessen werden, zum Beispiel unter Ausnutzung des Photoeffektes. Ein Beispiel für Photonendetektoren bilden Photokathoden. Unter dem Begriff Intensität soll im Rahmen der Anmeldung insbesondere die Anzahl von Photonen verstanden werden, die zum Beispiel bei einer bestimmten Energie oder Wellenlänge gemessen werden. Mit Hilfe von Spiegeln und Gitter, welche eine konkave Oberfläche aufweisen, lassen sich durch Beugungseffekte Lichtstrahlen in verschiedene Oberflächenbereiche beziehungsweise Kanäle solcher Detektoren lenken, so dass sich jedem Kanal ein bestimmter Wellenlängenbereich zuordnen lässt.

Unter dem Begriff Oberflächeneigenschaften sollen im Rahmen der Anmeldung insbesondere die Form und die Reflektionseigenschaften einer Oberfläche in Bezug auf Ionen, Atome oder Licht verstanden werden. Dies kann das spektrale Reflektionsvermögen betreffen, zum Beispiel im Falle von Licht, oder die Geschwindigkeitsverteilung im Falle von Teilchen oder allgemein die Energieverteilung nach der Reflektion von Teilchen oder von Licht an der Oberfläche. Die Oberflächeneigenschaften umfassen im Rahmen von Reflektionen auch Materialeigenschaften der Oberfläche. Diese umfassen im Rahmen der Anmeldung insbesondere die Masse der Atome an der Oberfläche eines Targets.

Die Rauschanteile eines Signals können mit aus der Signalverarbeitung bekannten Methoden wie zum Beispiel Glättungsverfahren entfernt werden, zum Beispiel durch LTI-filter oder auch Nichtlineare Filter wie Rangordnungsfilter oder Sigmafilter.

Unter Grundrauschen soll im Rahmen der Anmeldung das Signal der Lichtintensität verstanden werden, welches der Detektor für Energien oberhalb des Absolutwertes der angelegten Spannung beziehungsweise unterhalb des Negativen des Absolutwertes der Spannung aufzeichnet.

Unter dem Reinheitsgrad soll im Rahmen der Anmeldung der Anteil der Atome, insbesondere stabiler Isotope, eines Elements in einem beliebigen Gemisch verschiedener Atome verstanden werden. Der Begriff des Reinheitsgrades bezieht sich erfindungsgemäß insbesondere auf homogene Targets.

Unter einem Niederdruckplasma soll im Rahmen der Erfindung insbesondere ein Plasma mit einem Druck von höchstens 0,1 Pascal verstanden werden. Bekanntermaßen ist 1 Pascal gleich $10^{-5}$ Bar. Zur Erzeugung des Niederdruckplasmas können alle nach dem Stand der Technik bekannten Verfahren eingesetzt werden.

Alternativ kann der Energiewert $E_{max}$ bestimmt werden als die kleinste gemessene Energie, ab der alle Werte der Intensität der Wertekurve größer oder gleich sind wie ein Intensitätswert, der sich als die Summe des Mittelwertes des Grundrauschens des Detektorsignals und dem ein-, zwei- oder dreifachen oder anderer Vielfacher der Standardabweichung des Signals des Grundrauschens ergibt. Bei der Bestimmung des Mittelwertes und der Standardabweichung werden gemäß der erfindungsgemäßen Definition des Grundrauschens nur Werte oberhalb des Absolutwertes der Spannung beziehungsweise unterhalb des Negativen des Absolutwertes der Spannung berücksichtigt. Mit größeren Messzeiten beziehungsweise Integrationszeiten nimmt die Standardabweichung bekanntermaßen ab.

Alternativ kann zunächst das Konfidenzintervall bestimmt werden, innerhalb dessen der Mittelwert der Intensität des Grundrauschens mit einer Wahrscheinlichkeit W zu finden ist. Der Wert von $E_{max}$ kann dann bestimmt werden als der kleinste Energiewert beziehungsweise kleinste gemessene Energiewert, bei dem alle Werte der gemessenen Intensität größer oder gleich sind wie der Wert der oberen Grenze des Konfidenzintervalls. Hierbei orientiert sich W an der Genauigkeitsanforderung der Bestimmung von $E_{max}$. Die Grenzen des Konfidenzintervalls können durch größere Messzeiten beziehungsweise eine höhere Anzahl von Messwerten verkleinert werden. Die Genauigkeit der Bestimmung beziehungsweise Messung kann durch größere Messzeiten vergrößert werden.

Das Target umfasst eine leitfähige Oberfläche, damit eine Spannung an diese Oberfläche angelegt werden kann. Es ist aus dem Stand der Technik bekannt, dass das Plasmapotenzial vernachlässigt werden kann gegenüber der angelegten Spannung in einem Bereich von - 40 V bis -500 V oder für Spannungen mit größerem Absolutbetrag. Die Umrechnung der Spannung in die zugehörige Energie kann dabei durch Multiplikation mit der Elementarladung erfolgen, wie es aus dem Stand der Technik bekannt ist. Man kann dann insbesondere die Energie in Einheiten von Elektronenvolt erhalten. Erfindungsgemäß werden insbesondere Wasserstoff- und Deuteriumionen mit einer Ladungszahl z=1 betrachtet. Für Ionen mit einer Ladungszahl z mit einem Absolutwert größer als 1 muss bekanntermaßen der Absolutwert dieser Ladungszahl z mit der Spannung und der Elementarladung multipliziert werden, um die zugehörige (kinetische) Energie zu erhalten.

Zur Bestimmung des Energiewertes $E_{max}$ sind die Binärstöße der Ionen aus dem Plasma an der Oberfläche von primärer Bedeutung und nicht Vielfachreflektionen. Mit größerer Rauigkeit erhöhen sich die Messzeiten, damit genügend viele Binärstöße stattfinden. Dies stellt aber kein prinzipielles Hindernis dar.

Die erfindungsgemäße Bestimmung der Oberflächeneigenschaften wird im Folgenden näher erläutert. Erfindungsgemäß ist es gelungen, bei sehr allgemeinen Bedingungen in Niederdruckplasmen das Reflektionsvermögen von Oberflächen bei bestimmten Wellenlängen im sichtbaren Bereich in situ zu messen. Zwei atomphysikalische Effekte und ein Effekt der Plasmaphysik erlauben es, sowohl die Reflektion von Wasserstoffteilchen (Energie- und Winkelverteilung) als auch die spektrale Reflektion deren Balmer-Linien zu bestimmen.

Es ist bekannt, dass Plasma-Ionen aufgrund ihrer positiven elektrischen Ladung in einem elektrischen Feld beschleunigt werden können.

Dieses Prinzip wird angewendet um schnelle Ionen vor einer Oberfläche zu produzieren. Dazu wird ein relativ zum Plasmapotential negatives elektrisches Potential (bis zu -500 V) an die Oberfläche gelegt, um die positiv geladenen Teilchen wie H⁺ oder D⁺ (also einfach positiv geladene Wasserstoff- bzw. Deuterium-Ionen) zu beschleunigen. Der Energiebereich der Ionen (100 eV bis 500 eV) entspricht dem von Ionenstrahlexperimenten. Zur Realisierung der Vorspannung muss die Oberfläche elektrisch leitend sein. Optimale Bedingungen stellen daher metallische Oberflächen dar, auch weil deren Oberflächen nicht stark aufgeheizt werden. Wenn die Plasmatemperatur (also die Plasmaionentemperatur $T_i$ und die Plasmaelektronentemperatur $T_e$) beziehungsweise die zu dieser Temperatur zugehörige Energie deutlich niedriger ist als die Energie der beschleunigten Ionen $E_0$ ($T_{i,e}/E_0 \ll 1$), kann man praktisch über Ionenbestrahlung der Oberfläche sprechen. In den in Figur 1 diskutierten Laborexperimenten werden die zurückgestreuten Atome oder Ionen sofort in einem Massen-Energie-Detektor analysiert und die Information zur Energie- und Winkelverteilung abgeleitet. Zur Realisierung des in situ Messverfahrens müssen folgende Bedingungen erfüllt sein:

i. Die Energie- und Winkelverteilung der Atome im Plasma darf sich nicht oder nur sehr langsam mit der Zeit vor der Oberfläche ändern.

ii. Die Anzahl von solchen Atomen oder die Größe, die mit der Anzahl der Atome linear verbunden ist, wird ohne Störung mit dem anderen speziellen Messverfahren nachgewiesen.

Die erste Bedingung wird nur im Fall von Niederdruckplasmen (die Plasmadichte $N_i$ ist kleiner als $10^{18}$ m⁻³) erreicht. Hier werden die Stöße der schnellen Atome mit den Plasmateilchen so selten, dass die ursprüngliche Winkel- und Energieverteilung der Atome ausreichend lange erhalten bleibt. Niederdruckplasmen haben einen weiteren Vorteil. Die Elektronentemperatur wird in diesem Fall höher (von 5 eV bis 10 eV), so dass sehr komplexe molekulare Prozesse nicht vorkommen. Da die Moleküle schnell dissoziieren, besteht das Plasma in diesem Fall im Wesentlichen nur aus H⁺-Ionen und Elektronen, um die Quasineutralität einzuhalten. Die Energie- und Winkelverteilung wird in diesem Fall nur von einer Sorte der Teilchen, nämlich H⁺ oder D⁺ gemessen. Die Bedingungen der Ionenstrahl-Experimente werden besser erfüllt.

Bei Hochdruckplasmen wurden solche schnellen Atome tatsächlich beobachtet [7, 8]. Aber durch die komplexe Molekularphysik hinsichtlich der Entstehung der angeregten Zuständen von Atomen, sowie eine sehr starke und unbekannte Inhomogenität der Ionensorten (H⁺, H₂⁺, H₃⁺) sowie ihre Thermalisierung durch hohe Plasmadichte sind Messungen der Energie- und Winkelverteilung von H⁺ Ionen in diesen Plasmen nicht möglich [7, 8, 9]. Man ist dort nicht in der Lage die Prozesse so zu quantifizieren, dass diese direkt für die erfindungsgemäße Fragestellung angewendet werden können.

Der Nachteil der Niederdruckplasmen besteht aber darin, dass der Fluss von Plasma-Ionen zum Substrat oder zur Oberfläche so niedrig ist, dass man die Atome im Plasma nicht mit herkömmlichen Diagnostiken nachweisen kann. Erfindungsgemäß ist es gelungen, die Intensität der Balmer-Linien der Wasserstoffatome sehr stark zu erhöhen. Dabei wird eine Energieresonanz zwischen den metastabilen Zuständen von Edelgasatomen und den angeregten Zuständen von Wasserstoffatomen angewendet [10]:

$$Rg^* + H \rightarrow Rg + H^*. \qquad (A)$$

Hierbei ist Rg* ein Edelgasatom (Rg = Ar, Kr, He, Ne, Xe) im angeregten Zustand und H* ein H- oder D-Atom im angeregten Zustand. Durch die Reaktion (A) ist man in der Lage die Emission der Balmer-Linien der reflektierenden Atome so stark zu erhöhen, dass man diese Atome und somit ihre Energie- und Winkelverteilung in Niederdruckplasmen gut bestimmen kann. Die Bedingung (ii) wird damit vollständig erfüllt. Das Verfahren zur Beobachtung der Energie- und Winkelverteilung der reflektierten H- und D-Atome stellt den Kern der Erfindung dar. Die Beobachtung ist in den Mixplasmen Ar-H, Kr-H oder Ar-D, Kr-D möglich. Bei der Verwendung von den anderen Edelgasen ist die Resonanz sehr schwach und kaum messbar und daher mit deutlich längeren Messzeiten (größere Integrationszeiten) verbunden.

Das erfindungsgemäße Verfahren ermöglicht nicht nur die Messung der Energie- und Winkelverteilung, sondern auch die Messung des spektralen beziehungsweise spekularen Reflektionsvermögens [4], also des Reflektionsvermögens bei spiegelartigen Reflektionen, der Oberfläche anhand von induzierten Balmer-Linien (Reaktion A) der Wasserstoffatome.

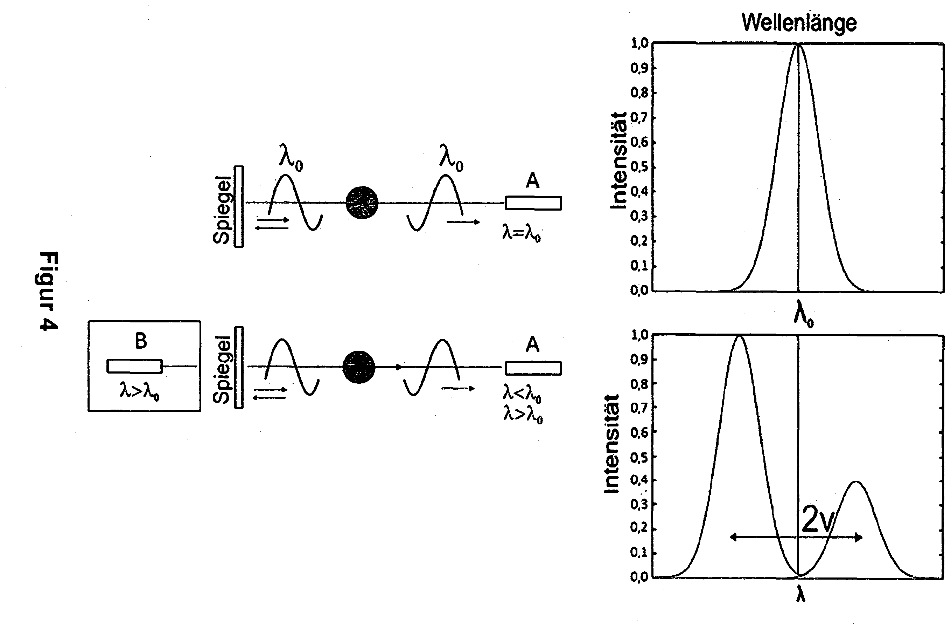

Jedes angeregte Atom emittiert eine bestimmte Anzahl von Photonen, deren Energie dem Energieunterschied der Quantenzustände des Atoms entspricht, wie zum Beispiel Balmer-Linien vom Wasserstoffatom (von Hauptquantenzahlen n>2 zu n=2). Die gemessene Energie beziehungsweise die Wellenlänge der Photonen werden im Detektor A standardgemäß gemessen (Figur 4). Liegt keine relative Bewegung zwischen Atom und Beobachter (Detektor) vor, spricht man von unverschobener Spektralposition oder Wellenlänge. Bewegt sich das Atom relativ zum Beobachter, verschiebt sich die Position der Wellenlänge durch den Dopplereffekt in die Richtung der Bewegung des Atoms relativ zum Beobachter (Detektor). In Figur 4 wird der Dopplereffekt gezeigt, der vor einem Spiegel stattfindet und dessen Reflektionsvermögen bestimmt werden soll. Beim ruhendem Atom (Geschwindigkeit $v = 0$) misst der Detektor A die Photonen, die sich direkt vom Atom in Richtung des Detektors A bewegen (nach rechts) aber auch die Photonen, die an der spiegelnden Oberfläche reflektiert werden (nach links) und sich dann in Richtung des Detektors bewegen. Die beiden Photonenflüsse erscheinen an der gleichen Position des Detektors. Diese Position entspricht der unverschobenen Wellenlänge $\lambda_0$. Man kann die reflektierten und nicht-reflektierten Photonen spektral nicht unterscheiden. Eine Messung des Reflektionsvermögens ist demzufolge für ruhende Atome nicht möglich.

Beim schnell bewegten Atom ($v > 0$) sieht das Bild anders aus. So werden zum Beispiel die Photonen, die sich in Richtung des Detektors A ausbreiten, mit einer blauverschobenen, das heißt kleineren Wellenlänge, detektiert. Dagegen werden die Photonen, die sich zunächst in Richtung des Spiegels ausbreiten, mit einer Rotverschiebung aufgenommen. (Man könnte das Bild auch so darstellen, als ob statt des Spiegels ein Detektor B die sich nach links bewegenden Photonen aufzeichnet.) Aus dem Intensitätsverhältnis der rot- und blauverschoben Linien kann man direkt das Reflektionsvermögen des Spiegels herleiten. Die verschobenen Linien müssen weit genug voneinander getrennt sein, um sie beide gleichzeitig messen zu können.

Bei dieser einfachen Lösung ergeben sich zwei Fragen:

> iii. Wie kann man die Atome im Plasma vor dem Spiegel so beschleunigen, dass man die beide Linien trennen und gut auflösen kann?
> iv. Wie erreicht man eine genügend hohe Linienintensität in Niederdruckplasmen?

Die Fragen (iii) und (iv) sind mit den Fragen beziehungsweise Bedingungen (i) und (ii) im Wesentlichen identisch. Die Beschleunigung der Atome (iii) erreicht man, indem man ein negatives Potential an die Oberfläche legt. Die hohe Intensität der Wasserstofflinien wird durch Prozess (A) garantiert. Durch den Dopplereffekt sind die Reflektionsmessungen der Spektrallinien eindeutig. Weil Wasserstoff und Deuterium die leichtesten Atome sind, werden mit ihrer Verwendung die genauesten Messungen der Reflektion erreicht. Im Gegensatz zu schwereren Atomen erreichen sie die größte Geschwindigkeit bei gleicher kinetischer Energie, da $v^2 = 2E/m$ gilt.

Zusammengefasst ergibt sich ein simultanes Verfahren zur Messung der Reflektionseigenschaften von Wasserstoffteilchen an der Oberfläche, das heißt ihre Energie- und Winkelverteilung, sowie zur Messung des spektralen Reflektionsvermögens von Wasserstofflinien in Laborplasmen ohne Entnahme des Substrates aus dem Plasma und Unterbrechung des Plasmabetriebs.

Das erfindungsgemäße in situ Verfahren zur Bestimmung der Energie- und Teilchenreflektion von Wasserstoff- bzw. Deuterium-Atome wurde in einem Plasma mit folgenden Parametern an der linearen Anlage PSI-2 [11] getestet: Der Plasmadruck lag bei $10^{-3}$ Pa bis $10^{-1}$ Pa, die Plasmadichte bei $10^{17}$ m$^{-3}$ bis $10^{19}$ m$^{-3}$, die Gasflüsse (Ar/D oder Ar/H) bei 10 sccm ($1.66 \cdot 10^{-7}$ m$^3$/s) bis 100 sccm ($1.66 \cdot 10^{-6}$ m$^3$/s), das Mischverhältnis von Ar/D oder Ar/H bei 1:1, die Plasmatemperatur bei 3 eV bis 10 eV, die angelegte Spannung an Oberfläche bei -50 V bis -200 V.

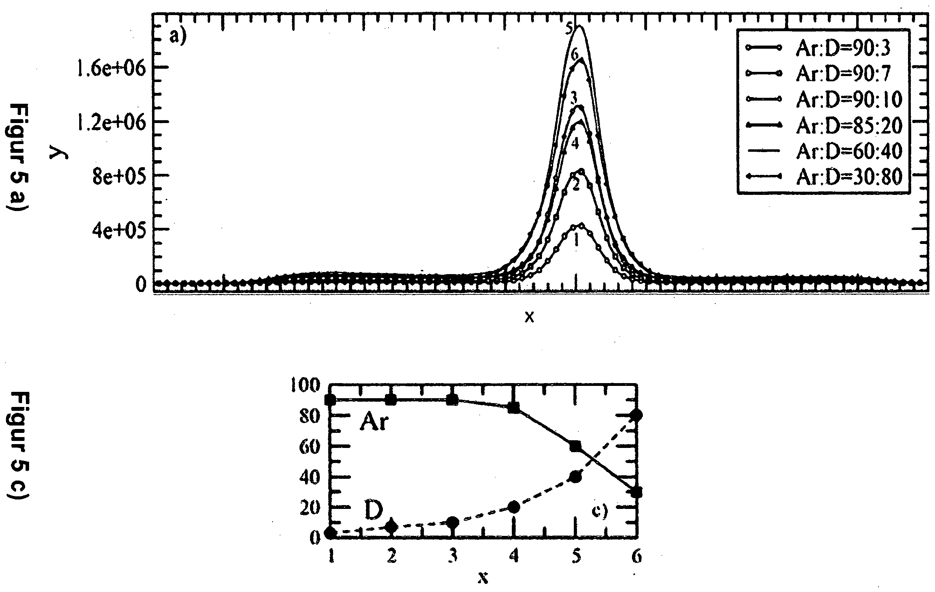

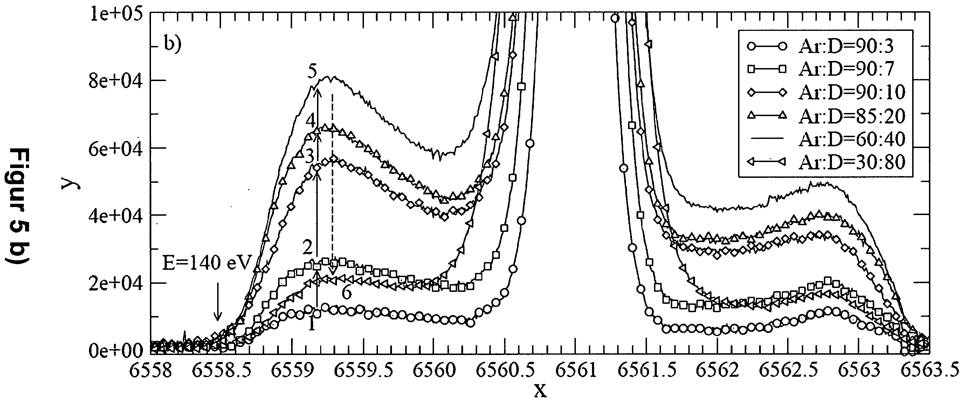

Zuerst (Figur 5) wird gezeigt, dass das Signal der reflektierten Atome durch den Resonanzprozess (A) deutlich verstärkt wird. Man sieht in Figur 5, dass die Emissionsintensität der reflektierten Atome durch das Ar-H Verhältnis stark beeinflusst wird und für reines D oder reines Ar Plasma im Wesentlichen verschwindet.

Das Verhältnis 1:1 von Ar:H oder Ar:D bietet die besten Bedingungen, um die Reflektionsmessungen der Teilchen und des Lichts durchzuführen.

Es kann gezeigt werden, dass es möglich ist, beim Anlegen von verschiedenen Potentialen an die Oberfläche des Targets, die Energie- und Winkelverteilung der Atome zu messen.

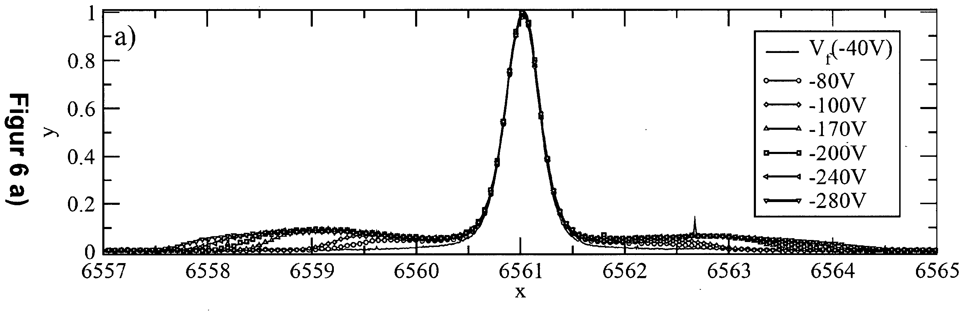

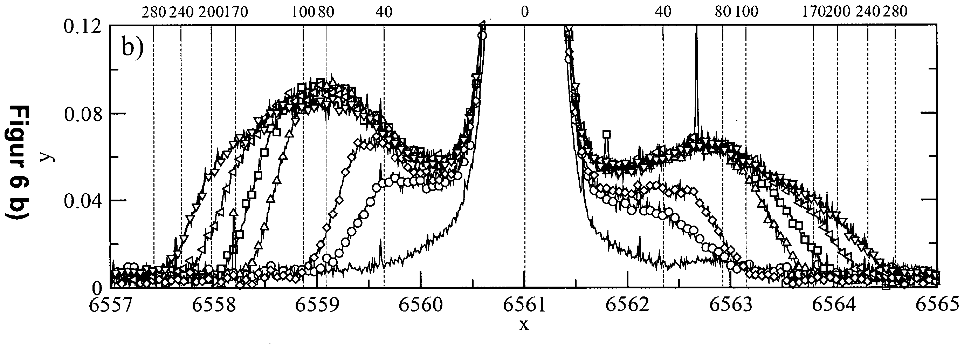

Figur 6 zeigt die Emission der Deuterium-Atome unter der Variation des Potentials am Wolfram- Substrat.

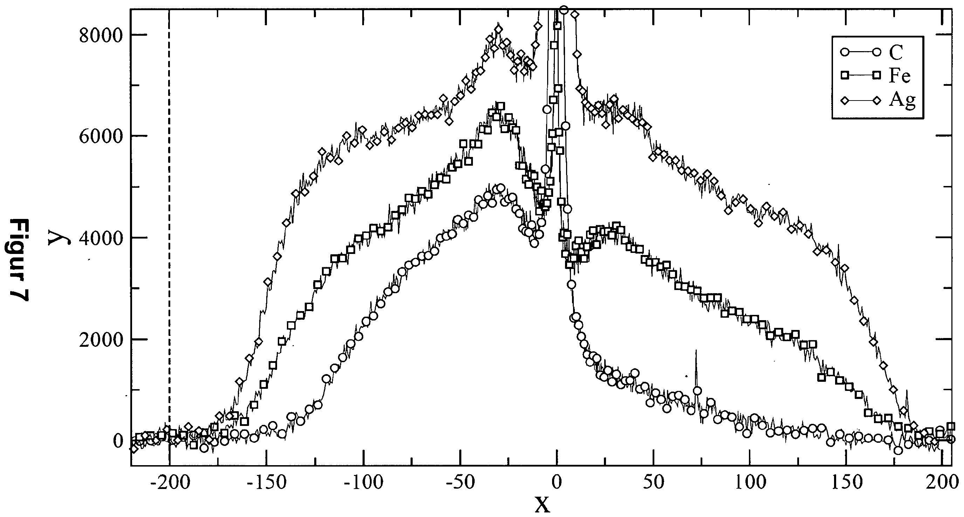

Die mittleren Energien der reflektierten Atome können sogar ohne detaillierte Analyse der Daten festgestellt werden. Die unterschiedlichen Symbole der Messkurven der Figur stehen für verschiedene kinetische Energien der Atome, die dem angelegten Potential der Oberfläche entsprechen. Die Breite der Doppler-verschobenen Flügel ist proportional zur Geschwindigkeit der Atome und entspricht somit der direkten Messgröße der Energieverteilung. So zeigen die Atome mit einer kinetischen Energie von 280 eV die stärkste Ausbreitung gegenüber allen anderen Atomen beziehungsweise deren kinetischen Energien. Die den Atomen mit einer kinetischen Energie von 100 eV entsprechende Messkurve weist eine deutlich kleinere Fläche des Signals auf. Der Verlauf der Energieverteilung, wie er in der oben beschrieben ist, kann damit genutzt werden, um das Material der Oberfläche zu bestimmen, was zum Beispiel beim Prozess der Oberflächenbeschichtung häufig notwendig ist. Figur 7 vergleicht die Energieverteilungen der an einem Silber (Ag), Eisen (Fe) und Kohlenstoffsubstrat (C) reflektierten Atomen bei gleichem angelegten Potential (-200 V). Im Fall des Kohlenstoffsubstrates erkennt man die deutlich schmalere Dopplerverbreiterung der Flügel und somit die kleinere Energie der reflektierten H-Atome (bei gleichem angelegten Potential) gegenüber dem Silber- oder Eisensubstrat. Durch die kleinere Masse der Kohlenstoffatome ($m=12,011$ $u_0$) gegenüber den Eisenatomen ($m=55,845$ $u_0$) oder den Silberatomen ($m=107,8682$ $u_0$) verlieren die Wasserstoffionen beim Stoß mit der Kohlenstoffoberfläche mehr von ihrer Einfallsenergie. Das führt dazu, dass die reflektierten neutralen Wasserstoffatome eine geringere Energie besitzen als wenn sie auf das Silber- oder Eisensubstrat treffen. Entsprechende Resultate ergeben sich zum Beispiel auch für den Vergleich von Wolfram (W)-Substraten und Aluminium (Al)-Substraten.

Die obigen Messungen zeigen, dass die Energie der am Kohlenstoffsubstrat reflektierten Wasserstoffatome um etwa 50 eV kleiner ist als die Energie der am Silbersubstrat reflektierten Atome. Die einfache Formel [6] bestätigt das gemessene Ergebnis. Demzufolge kann das Messverfahren Informationen über die Art des Materials der Oberfläche liefern. Die Messgenauigkeit wird nur durch die Statistik und Auflösung des verwendeten Detektors (Spektrometer) begrenzt. Mit der Auflösung $\frac{\lambda}{\Delta\lambda}$ von etwa $10^5$ im sichtbaren Bereich des elektromagnetischen Spektrums ist man in der Lage, zwischen den verschiedenen Metallen zu differenzieren. Das Verhältnis der Energie $E_{max}$ eines Substrats, welches Atome mit größerer Masse umfasst zu der Energie $E_{max}$ eines Substrats, welches Atome mit kleinerer Masse umfasst, liegt für die hier genannten Eisen-, Silber- und Kohlenstoff-Targets bei mindestens 5 %. Die verschiedenen Materialien der Targets lassen sich also anhand der Energie $E_{max}$ voneinander unterscheiden. Das zur Unterscheidung der Materialien von Targets notwendige Verhältnis der verschiedenen Energien $E_{max}$ richtet sich allgemein unter anderem nach den Genauigkeitsanforderungen beziehungsweise den zur Verfügung stehenden Messzeiten beziehungsweise Integrationszeiten.

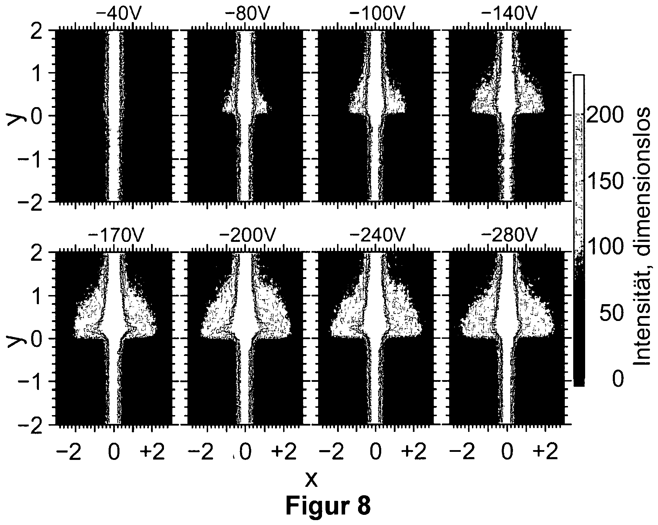

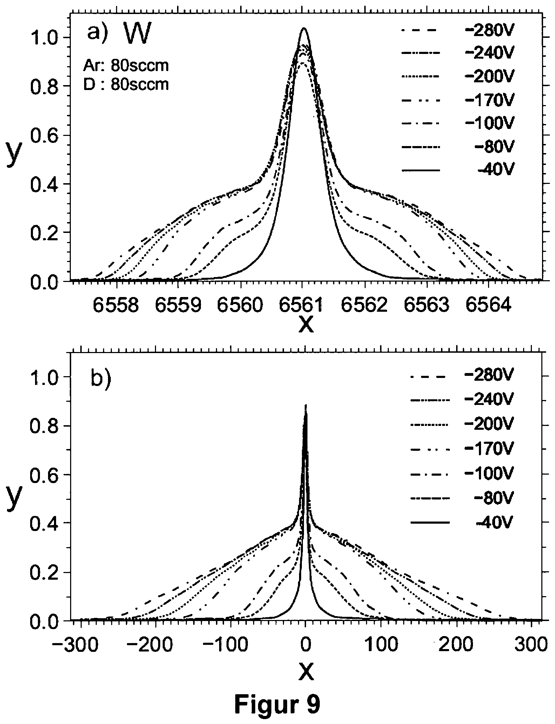

Der relative Verlauf der Emissionsprofile ist für verschiedene Materialien ähnlich. Die allgemeine Profilform hängt nur von der Beobachtungsrichtung des Detektors (Spektrometer) ab. Die Beobachtungen unter verschiedenen Winkeln können benutzt werden, um die Winkelverteilung der reflektierten Atome zu ermitteln. Figur 8 zeigt Messungen für eine Beobachtung unter dem Winkel von 90° zur Normale, das heißt der Sichtstrahl verläuft parallel über die Oberfläche. Die Plasmabedingungen sind identisch mit den Bedingungen aus Figur 6. Diese Beobachtungsrichtung ist frei von spektraler Reflektionsmessung, das heißt, die rotverschobene Komponente stammt in diesem Spezialfall nicht von der Reflektion, sondern direkt von den Teilchen, die sich vom Detektor weg bewegen. Genauso wie in Figur 6 gezeigt wurde, sieht man auch hier wie die Energie der Atome proportional zum angelegten Potential variiert. Figur 9(a) zeigt den gleichen Scan noch einmal in einem Diagramm, wobei über die ersten 5 mm entlang der z-Achse vor der Oberfläche, das heißt in Richtung senkrecht zur Oberfläche, integriert wurde. Darunter zeigt Figur 9(b) die Energie der Teilchen.

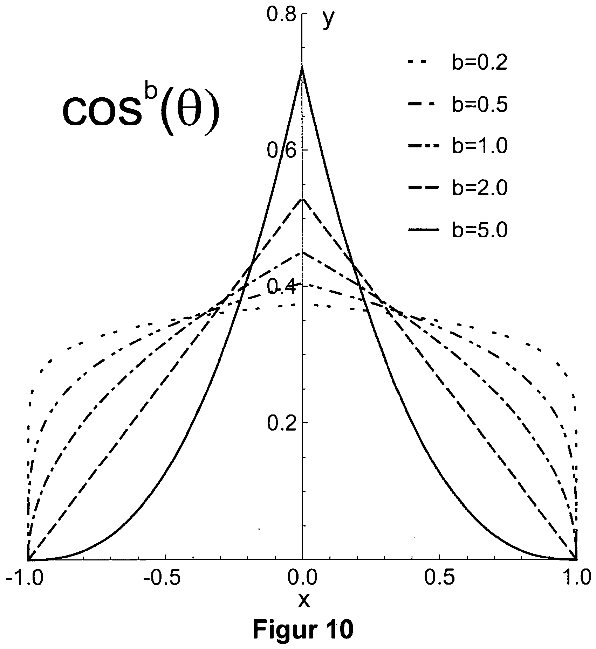

Aus Figur 9 (b) kann die Winkelverteilung der Wasserstoffteilchen bestimmt werden. Man kann beziehungsweise muss die gemessenen Daten mit theoretischen Modellen vergleichen (4). Figur 10 zeigt die mögliche Winkelverteilung der Atome. So können die gemessenen Daten von Figur 9(b) mit der Winkelverteilung von $\cos^b(\theta)$ mit $b=1,0 - 2,0$ gut reproduziert werden.

Gemäß einer Ausführung des erfindungsgemäßen Verfahrens zur Ermittlung des spektralen Reflektionsvermögens kann eine Integration über den blau- und rotverschobenen Bereich erfolgen und folgende Schritte umfassen:

a) Integration über den blauverschobenen Bereich der Wertekurve von der Wellenlänge $\lambda_0 - \Delta\lambda_{max}$ bis zu einer Wellenlänge $\lambda_0 - \Delta\lambda_{max}\sin(\theta)$, wobei $\lambda_0$ der unverschobenen Balmerlinien entspricht. Die Größe $\Delta\lambda_{max}$ ist die Differenz zwischen der Balmer-Linie $\lambda_0$ und der Wellenlänge $\lambda_{max}$, welche gemäß Schritt g) in Anspruch 1 zu der Energie $E_{max}$ gehört.
b) Integration über den rotverschobenen Bereich der Wertekurve von der Wellenlänge $\lambda_0 + \Delta\lambda_{max}\sin(\theta)$ bis zu einer Wellenlänge $\lambda_0 + \Delta\lambda_{max}$.
c) Bestimmung des spektralen Reflektionsvermögens als Verhältnis zwischen kleinerem zu größerem Integral

Ein alternatives Verfahren zur Ermittlung des spektralen Reflektionsvermögens durch Integration über den blau- und rotverschobenen Bereich kann folgende Schritte umfassen:

a) Integration über den blauverschobenen Bereich der Wertekurve von der Wellenlänge $\lambda_0 - \Delta\lambda_{max}$, aus welcher

sich gemäß dem Verfahren im Hauptanspruch die Energie $E_{max}$ ergibt, bis zu einer Wellenlänge $\lambda_i$, wobei der Wert $\lambda_i$ kleiner ist als $\lambda_0 - \Delta\lambda_{max} \cdot \sin\theta$ mit der Differenz $\Delta\lambda_{max}$ zwischen der Wellenlänge $\lambda_0$, der Wellenlänge des Lichtes, welches von einem relativ zum Detektor ruhenden Atom emittiert wird, und der Wellenlänge $\lambda_{max}$.

b) Integration über den rotverschobenen Bereich der Wertekurve zwischen einer Wellenlänge $\lambda_i'$ bis zu dem Endpunkt $\lambda_0 + \Delta\lambda_{max}$ dieses Bereichs, wobei die Wellenlängen $\lambda_i$ und $\lambda_i'$ so gewählt werden, dass die beiden Integrationsintervalle gleich lang sind und $\lambda_i'$ grösser als $\lambda_0 + \Delta\lambda_{max} \cdot \sin\theta$ und kleiner als $\lambda_0 + \Delta\lambda_{max}$ ist

c) Bestimmung des spektralen Reflektionsvermögens als das Verhältnis zwischen kleinerem zu größerem Integral

Das Verfahren zur Messung des spektralen Reflektionsvermögens, das in Figur 4 skizziert ist, wird in den Figuren 5 bis 7 deutlich. Die rotverschobene Komponente ist ein Ergebnis der spektralen Reflektion an den Oberflächen. Man sieht es am Beispiel der Figur 7 deutlich. Die Reflektion von Silber ist deutlich höher als die Reflektion von Eisen und Kohlenstoff. Die Figur 11 zeigt Messungen der spektralen Reflektion.

Die Messung der Reflektion beziehungsweise Bestimmung des spektralen Reflektionsvermögens beruht auf dem Verhältnis des Integrals zwischen rot- und blauverschobener Komponente als Funktion der Wellenlänge $\lambda_i$ oder $\lambda_i'$ beziehungsweise der zu diesen Wellenlängen gehörenden Energiewerte $E_i$ und $E_{i'}$. Wenn die relative Genauigkeit dieser Messung der Reflektion beziehungsweise des spektralen Reflektionsvermögens betrachtet wird, also die Differenz der erfindungsgemäß bestimmten Werte des spektralen Reflektionsvermögens und von durch theoretische Berechnungen oder Labormessungen aus dem Stand der Technik bekannten Werten des spektralen Reflektionsvermögens, dividiert durch diese aus dem Stand der Technik bekannten Werte, so liegt diese Genauigkeit für alle Energiebereiche innerhalb von 20 %. Damit bietet das Messverfahren eine relativ robuste und alternative Methode, um das Reflektionsvermögen der Oberfläche (beziehungsweise Spiegel) in situ im Plasma zu bestimmen.

Das erfindungsgemäße Verfahren ist vorteilhaft dadurch gekennzeichnet, dass die Intensitätswerte der Wertekurve, welche bei einer angelegten Spannung von Null Volt ermittelt wird, von den Intensitätswerten einer bei einer von Null Volt verschiedenen Spannung ermittelten Wertekurve subtrahiert werden.

Vorteilhaft weist diese Differenz keine unerwünschten Spektrallinien beziehungsweise Artefakte im Spektrum auf. Diese Artefakte können zum Beispiel durch Stoßprozesse, welche zur Bildung von Molekülen führen, oder auch andere molekulare Prozesse in dem Plasma entstehen.

Das erfindungsgemäße Verfahren ist weiterhin vorteilhaft dadurch gekennzeichnet, dass der maximale Intensitätswert $\tilde{I}$ aus dem blau- und rotverschobenen Wellenlängenbereich der in Schritt e) in Anspruch 1 bestimmten Wertekurve bestimmt wird sowie die diesem Intensitätswert gemäß der Wertekurve zugehörige Wellenlänge X, danach die Differenz $\Delta\lambda = \lambda_0 - \tilde{\lambda}$, zwischen der Wellenlänge $\lambda_0$ und der Wellenlänge $\tilde{\lambda}$ berechnet wird, dann die Intensität $I_1$ bei $\lambda_0 + \Delta\lambda$ bestimmt wird und danach der Wert des spektralen Reflektionsvermögens bezüglich der spekularen Reflektion

$$r_S = \frac{I_1}{\tilde{I}}$$

beziehungsweise SpiegelReflektion $r_S$ gemäß berechnet wird.

Vorteilhaft kann hierdurch der Wert des spektralen Reflektionsvermögens bezüglich der spekularen Reflektion oder Spiegelreflektion ermittelt werden. Diese Reflektion betrifft den Anteil der Strahlung, welcher ohne Diffusion reflektiert wird. Wenn die Oberfläche insbesondere vollständig glatt ist, also zum Beispiel keine Mittenrauigkeit aufweist, wird die Strahlung vollständig ohne Diffusion reflektiert.

Das erfindungsgemäße Verfahren ist in einer vorteilhaften Ausführung gekennzeichnet durch die folgenden Schritte:

a) Ermittlung des Wertes der maximalen Intensität in dem Wellenlängenbereich zwischen der Wellenlänge $\lambda_0 - \Delta\lambda_{max}$ und der Wellenlänge $\lambda_0 - \Delta\lambda_{max} \sin(\theta)$.

b) Ermittlung des Wertes der maximalen Intensität in dem Wellenlängenbereich zwischen der Wellenlänge $\lambda_0 + \Delta\lambda_{max} \sin(\theta)$ und der Wellenlänge $\lambda_0 + \Delta\lambda_{max}$.

c) Ermittlung des spektralen Reflektionsvermögens durch Division des kleineren Wertes der Intensität durch den größeren Wert der Intensität, welche in den Schritten a) und b) ermittelt wurden

Vorteilhaft kann auf diese Weise einfach und schnell der Wert des spektralen Reflektionsvermögens der gesamten Reflektion ermittelt werden. Außerdem liegt hier ein besseres Signal-Rausch-Verhältnis (SRV) (Poissonprozess) vor als wenn das spektrale Reflektionsvermögen durch Integration über den rot- und blauverschobenen Bereich ermittelt wird. Das spektrale Reflektionsvermögen wird also mit der Genauigkeit der SRV bei der höchsten Intensität ermittelt. Für Silber als Targetmaterial wurde so ein spektrales Reflektionsvermögen von 0,94 in Ar:H Plasma bei -100 eV und einem Plasmadruck von 0,024 Pa gefunden. Der theoretische Wert liegt bei 0,96 [12].

Das erfindungsgemäße Verfahren ist vorteilhaft dadurch gekennzeichnet, dass aus einer Schar von Wertekurven, bei der jede Wertekurve bei einem unterschiedlichen Winkel $\theta$ in einem Bereich von 0° bis 90° gemessen wurde, die Wertekurve mit der höchsten Intensität ausgewählt wird.

Vorteilhaft lassen sich die relevanten Signalwerte bei hoher maximaler Intensität gut von den Intensitätswerten des Grundrauschens unterscheiden. Daher ist es von Vorteil, zunächst den Winkel $\theta$ zu bestimmen, bei dem die maximale Intensität der Wertekurve am höchsten ist. Das erfindungsgemäße Verfahren ist vorteilhaft dadurch gekennzeichnet, dass zur Ermittlung des Winkels $\theta$ mit der höchsten maximalen Intensität des Lichts die Wertekurve bei einem Winkel zwischen Detektor und dem Normalenvektor senkrecht auf die Oberfläche des Targets von $\theta = 90°$ bestimmt wird.

Vorteilhaft werden bei einem Winkel von $\theta = 90°$ nur Photonen berücksichtigt, welche direkt von den von der Oberfläche reflektierten Atomen emittiert werden. Hierdurch können vorteilhaft auch weitere Aussagen gewonnen werden, zum Beispiel über das Reflektionsverhalten der Atome an der Oberfläche des Targets.

Das erfindungsgemäße Verfahren ist vorteilhaft dadurch gekennzeichnet, dass die Winkelverteilung der Atome nach der Reflektion an der Oberfläche durch eine Anpassung von aus einem TRIM oder SRIM Code [5] bestimmten Wertekurven an die bei einem Winkel $\theta$, insbesondere einem Winkel $\theta = 90°$, gemessene Wertekurve bestimmt wird, wobei die Anpassung insbesondere mit der Methode der kleinsten Quadrate erfolgt.

Vorteilhaft kann die Winkelverteilung der an der Oberfläche reflektierten Atome, also die Anzahl der Atome, die jeweils in Richtung eines Winkels relativ zur Senkrechten der Oberfläche beziehungsweise der Oberflächennormalen des Targets reflektiert werden, mit der Ausrichtung des Detektors in nur einem Winkel bestimmt werden. Hierzu kann die in diesem Winkel gemessene Wertekurve mit Wertekurven aus theoretischen Modellen verglichen werden. Hierzu eignen sich zum Beispiel auf dem Monte-Carlo Verfahren basierende Methoden wie die aus dem Stand der Technik bekannten SRIM oder TRIM Codes [5]. Für die Anpassung der aus dem theoretischen Modell gewonnenen Werte an die gemessene Wertekurve beziehungsweise das Fit-Verfahren zur Bestimmung der in solchen Programmen verwendeten Parameter können bekannte Verfahren wie der auf der Methode der kleinsten Quadrate beruhende least-square Fit verwendet werden. Es können also zum Beispiel die Parameter ausgewählt werden, mit denen die berechneten Modellwerte gemäß der Methode der kleinsten Quadrate am besten mit der gemessenen Wertekurve übereinstimmen.

Das erfindungsgemäße Verfahren ist vorteilhaft dadurch gekennzeichnet, dass die Winkelverteilung der Atome nach der Reflektion an einer planaren Oberfläche eines Targets bestimmt wird, indem aus einer Schar von Wertekurven, welche ein Profil gemäß der Formel $cos^b(\theta)$ mit einem Winkel $\theta$ relativ zur Senkrechten der Oberfläche des Targets beziehungsweise zum Lot auf die Oberfläche des Targets und einem Formparameter b aufweisen, diejenige bestimmt wird, welche gemäß der Methode der kleinsten Quadrate am besten mit der bei einem Winkel $\theta$, insbesondere einem Winkel $\theta = 90°$, gemessenen Wertekurve übereinstimmt.

Vorteilhaft kann die Intensität $I(\theta)$ des Lichtes, welche von den Atomen nach der Reflektion emittiert wird, in Abhängigkeit von einem Winkel $\theta$ relativ zum Normalenvektor der Oberfläche des Targets, in welchem ein Detektor ausgerichtet werden kann, durch berechnete Wertekurven mit einem Profil gemäß $cos^b(\theta)$ approximiert werden. Zur Auswahl des geeigneten Formparameters b kann aus der Schar der so berechneten Wertekurven, insbesondere mit Werten des Formparameters b=1 bis b=2, mit der Methode der kleinsten Quadrate diejenige Wertekurve ausgewählt werden, welche mit der gemessenen Wertekurve am besten übereinstimmt. Die Normierung der gemessenen Wertekurve kann hierbei so erfolgen, dass ihr maximaler Wert der Intensität gleich eins ist.

Für große Winkel $\theta$, insbesondere bei Winkeln $\theta$ von mehr als 85° und ganz besonders bei einem Winkel $\theta = 90°$, werden vom Detektor nur die Photonen gemessen, die von den reflektierten Atomen emittiert werden und direkt zum Detektor gelangen und nicht auch die Photonen, die zunächst an der Oberfläche reflektiert werden. Die Abhängigkeit der Intensität des Lichtes von der jeweiligen gemessenen Energie des Lichtes beziehungsweise der Photonen, in welche die Dopplerverschiebung und damit der Winkel $\theta$ eingehen, gibt dann auch die Winkelverteilung der reflektierten Atome wieder. Die Profile dieser Verteilung stimmen bei Wahl eines geeigneten Skalierungsfaktors überein.

Das erfindungsgemäße Verfahren ist vorteilhaft dadurch gekennzeichnet, dass an die Oberfläche des Targets eine Spannung von -500 V bis 0 V angelegt wird.

Vorteilhaft kann durch Anlegen einer Spannung in diesem Bereich eine kinetische Energie der Ionen in dem Plasma bei dem Auftreffen auf die Targetoberfläche die Breite des Bereiches der rot- und blauverschobenen Wellenlängen und der Wert des Energiewertes $E_{max}$ variiert werden. Hierdurch können unter anderem die Werte des spektralen Reflektionsvermögens und der Masse $m_2$ der Atome der Oberfläche für verschiedene Spannung verglichen werden, um zum Beispiel Messfehler abzuschätzen.

Das erfindungsgemäße Verfahren ist vorteilhaft dadurch gekennzeichnet, dass der Druck im Niederdruckplasma 0,01 Pa bis 0,1 Pa beträgt.

Vorteilhaft kann durch Drücke des Niederdruckplasmas im Bereich von 0,01 Pa bis 0,1 Pa zum Beispiel die Bildung von Molekülen durch Stoßprozesse verringert werden.

Das erfindungsgemäße Verfahren ist vorteilhaft dadurch gekennzeichnet, dass das Plasma Argon oder Wasserstoff oder Deuterium oder Mischungen dieser Elemente umfasst.

Vorteilhaft ist das Energieintervall des jeweiligen Energiewertes $E_{max}$ zwischen zwei im Periodensystem benachbarten Elementen bei Verwendung von Elementen mit kleinen Kernladungszahlen Z<20 im Plasma, insbesondere bei Wasserstoff oder Deuterium, also bei einem kleinen festen Wert von $m_1$ für unterschiedliche (mögliche) Werte der Masse $m_2$ der Atome, welche von Oberfläche des Targets umfasst werden, größer als bei schwereren Elementen. Daher ist vorteilhaft die Zuordnung des Energiewertes $E_{max}$ zu der Masse der Atome des Elements, welches von der Oberfläche des Targets umfasst wird, bei leichten Elementen mit Kernladungszahlen Z<20, insbesondere bei Wasserstoff oder Deuterium, einfacher. Dies gilt insbesondere, wenn die Oberfläche des Targets ebenfalls Atome eines leichten Elements umfasst, insbesondere mit Kernladungszahlen Z<20.

Das erfindungsgemäße Verfahren ist vorteilhaft dadurch gekennzeichnet, dass die angelegte Spannung negativ ist.

In einem Plasma liegen in der Regel positiv geladene Ionen vor, so dass die Spannung zur Beschleunigung der Ionen in Richtung der Targetoberfläche negativ sein muss.

Das erfindungsgemäße Verfahren ist vorteilhaft dadurch gekennzeichnet, dass zur Bestimmung der Wertekurve Spektrallinien aus der Balmer-Serie der Atome, die von der Oberfläche des Targets reflektiert werden, und Dopplerverschiebungen dieser Spektrallinien gemessen werden.

Vorteilhaft kann erfindungsgemäß die Intensität der Spektrallinien der Balmer-Serie beziehungsweise der Balmer-Linien, stark erhöht werden und so die Intensitäts-, Winkel- und Energieverteilung des reflektierten Lichtes beziehungsweise der reflektierten Atome auch im Niederdruckplasma gemessen werden. Dies betrifft vor allem die Balmer-Serie von Wasserstoff oder Deuterium, insbesondere bei Wasserstoff die $H_\alpha$-, $H_\beta$- und $H_\gamma$- Linie und die entsprechenden Balmer-Linien bei Deuterium.

Das erfindungsgemäße Verfahren ist vorteilhaft dadurch gekennzeichnet, dass das Plasma Mischungen von Argon oder Krypton oder Wasserstoff oder Deuterium, insbesondere im Mischungsverhältnis Ar:H=1:1 oder Ar:D=1:1 umfasst.

Vorteilhaft kann bei diesem Mischungsverhältnis die Emission der Balmer-Linien der reflektierenden Atome besonders stark erhöht werden.

Das erfindungsgemäße Verfahren ist vorteilhaft dadurch gekennzeichnet, dass das Target Atome der Elemente Kohlenstoff oder Aluminium oder Wolfram oder Eisen oder Silber umfasst.

Vorteilhaft weisen die Elemente Kohlenstoff oder Aliminium Kernladungszahlen Z<20 auf.

Das erfindungsgemäße Verfahren ist vorteilhaft dadurch gekennzeichnet, dass das Target einen Reinheitsgrad von 95 % bis 100 %, insbesondere von 99,94 % bis 99,999 %, aufweist.

Vorteilhaft werden bei einem hohen Reinheitsgrad des Targets die Werte der Energie $E_{max}$ nicht verfälscht.

Das erfindungsgemäße Verfahren umfasst in einer vorteilhaften Ausführung die folgenden Schritte:
Die Voraussetzung für erfolgreiche Messungen ist das Anbringen von einem Spektrometer mit einer Auflösung besser als 10 pm an das zu untersuchende Plasma. Die Étendue des Spektrometers definiert die Integrationszeit der Messungen. Es ist dafür zu sorgen, dass es während der Messungen nicht zu einer Störung kommt.

Die Plasmabedingungen werden vorteilhaft wie folgt eingestellt.

1. Das Potential an der spiegelnden Oberfläche U beträgt -500 V bis -100 V.
2. Der Plasmadruck beträgt 0,01 Pa bis 0,10 Pa
3. Der Gasfluss für Ar/H (Argon/Wasserstoff) oder Ar/D (Argon/Deuterium)weist ein Verhältnis von circa 1:1 auf, bei Kr/H (Krypton/Wasserstoff) oder Kr/D (Krypton/Deuterium) ein Verhältnis von circa 3:7

Die Messungen erfolgen unter einem bestimmten Beobachtungswinkel zur Oberfläche. Für die Messungen des Reflektionsvermögens ist der Winkel 0° zur Oberflächennormalen optimal. Für die Messungen der Winkelverteilung der reflektierten Atome an der Oberfläche sind einer oder mehrere Beobachtungswinkel möglich.

a) Zuerst wird ein Spektrum (i) ohne angelegtes negatives Potential gemessen.
b) Dann wird ein Potential zwischen -200 V bis -100 V an die spiegelnde Oberfläche angelegt und man erhält ein Spektrum (ii), welches schon die Informationen über das spektrale Reflektionsvermögen der Oberfläche beinhaltet.
c) Das Spektrum (i) wird vom Spektrum (ii) subtrahiert, beziehungsweise die Intensitätswerte aus diesen Spektren werden subtrahiert. Diese Differenz wird hier als Bild (III) bezeichnet und ist in Figur 7 und in Figur 10 schematisch dargestellt.
d) Das spektrale Reflektionsvermögen der spiegelnden Oberfläche kann nun ohne zusätzliche Information berechnet werden, indem das Integral der rotverschobenen Komponente der Balmer-Linie durch das Integral der blauverschobenen Komponente der Balmer-Linie vom Bild (III) dividiert wird. Die Messungen können für Balmer-Linien der Wasserstoffatome durchgeführt werden. Abweichungen in der Form der rot- und der blauverschobenen Komponenten deuten auf eine diffuse Oberfläche hin.
e) Für die Bestimmung der Winkel- und Energieverteilung der H- bzw. D-Atome ist folgende Vorgehensweise notwendig. Zuerst wird ein Monte-Carlo-Code benutzt, der in einer ersten Näherung die Energie- und Winkelverteilung der Atome vorhersagen kann. So wird zum Beispiel sehr häufig der Code TRIM oder SRIM (www.srim.org) angewendet. Man bekommt die theoretischen Werte der erwarteten Spektren. Man parametrisiert die Profile anhand von mathematischen Funktionen. So hat sich zum Beispiel die $cos^b(\theta)$ Funktion für die Winkelverteilung etabliert, wobei der Parameter b eine unbekannte zu bestimmende Größe ist.

f) Unter der Berücksichtigung des eingestellten Winkels des Detektors zur Oberfläche, siehe Figur 1 und der Energie- und Winkelverteilung gemäß dem Profil $cos^b(\theta)$ werden die freien Parameter der Verteilung angepasst (z. B. Parameter b). Die Anpassung erfolgt anhand eines nichtlinearen Fits von der Messung in Figur 7 und des Profils $cos^b(\theta)$. Damit werden die Größen der Winkel- und (oder) der Energieverteilung endgültig bestimmt.

Eine Vorrichtung zur Durchführung des Verfahrens nach einem der vorigen Ansprüche kann beispielsweise eine Quelle für Niederdruckplasmen, eine Spannungsquelle, ein Target und einen Photonendetektor [10, 11] umfassen.

Ausführungsbeispiel

Nachfolgend wird der Gegenstand der Erfindung anhand von Figuren näher erläutert, ohne dass der Gegenstand der Erfindung dadurch beschränkt wird. Es ist gezeigt:

Figur 1: Messaufbau zur Bestimmung der Energie- und Winkelverteilung von gestreuten Teilchen an einer Substratoberfläche.

Figur 2 a): Schema der Labormessungen von Reflektionsvermögen des Spiegels. Figur 2 b): Anwendung der Spiegeloberfläche bei der Kontrolle des technologischen Prozesses während des Plasmabetriebs.

Figur 3: schematische Skizze zur Reflektion von schnellen Plasma-Ionen ($H^+$) an der Substratoberfläche und zur Erzeugung von schnellen neutralen Atomen (H) im Plasma.

Figur 4: Schematische Darstellung des Effekts der Dopplerverschiebung vor spiegelnden Oberflächen.

Figur 5 a): Wertekurven über den gesamten gemessenen Intensitätsbereich von reflektierten Deuterium-Atome unter dem Winkel von 35° zur Oberflächennormalen eines Wolfram (W)-Substrats für verschiedene Mischungsverhältnisse von Argon und Deuterium.

Figur 5 b): Darstellung eines begrenzten Intensitätsbereichs zu dieser Messung, in dem die Maxima durch die Dopplerverschiebung erkennbar sind.

Figur 5 c) : Werte der diesen Mischungsverhältnissen entsprechenden Gasflüsse

Figur 6 a): Rohdaten zur Emission von reflektierten D-Atomen an einem Wolfram-Substrat für Ar-D Plasmen für verschiedene an die Oberfläche des Targets angelegte Spannungen.

Figur 6 b): Rohdaten zu dieser Messung in einem Intensitätsbereich, in welchem die Maxima durch die Dopplerverschiebung erkennbar sind.

Figur 7: Vergleich der Energieverteilung von an einem Kohlenstoff (C)-, Silber (Ag)- und Eisen (Fe)-Substrat reflektierten Wasserstoffatomen

Figur 8: Rohdaten der Intensität der Emission von reflektierten D-Atomen an einem W-Substrat für Ar-D Plasmen bei einem Winkel $\theta = 90°$

Figur 9: Rohdaten der Intensität der Emission von reflektierten D-Atomen an einem W-Substrat für Ar-D Plasmen nach Integration über den räumlichen Bereich zwischen der Oberfläche und einer Fläche, welche aus der Verschiebung der Oberfläche bis zu einem Abstand von 5 mm in Richtung senkrecht zur Oberfläche hervorgeht. Der Detektorwinkel, also der Winkel $\theta$, beträgt 90° relativ zur Oberflächennormalen.

Figur 10: Winkelverteilung der reflektierten Atome, gerechnet für verschiedene Formparameter b bei einem Winkel $\theta = 90°$

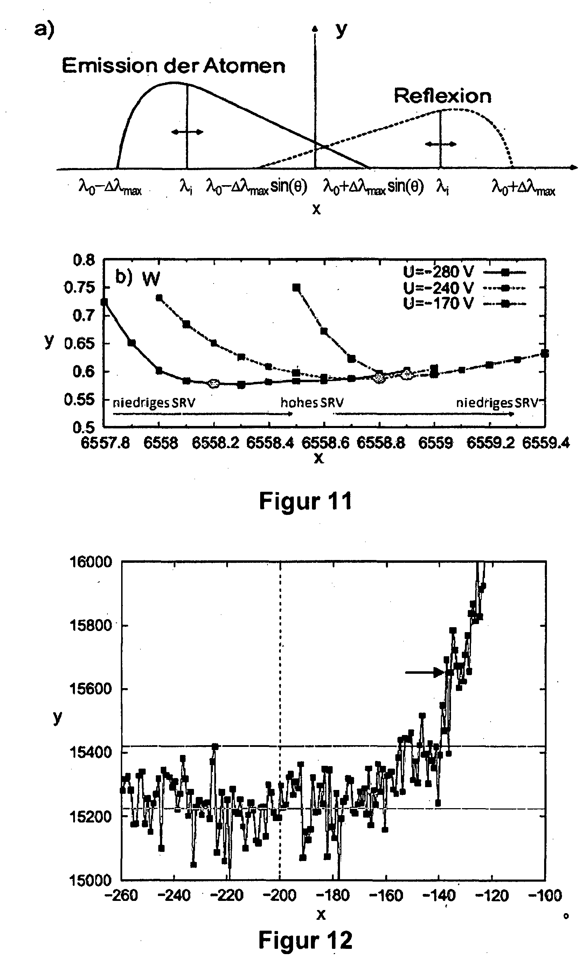

Figur 11: Messungen der spektralen Reflektion einer Wolfram (W)-Oberfläche mit einem Argon-Deuterium (Ar-D)-Plasma. Das spektrale Reflektionsvermögen liegt im Bereich von 0,55 bis 0,6. Der theoretische Wert ist 0,504 [12].

Figur 12: Differenz der Intensitäten zwischen den beiden Fällen, dass -200 V Spannung und dass keine Spannung an die Oberfläche des Targets angelegt wird. Gezeigt wird auch der Energiewert $E_{max}$. Das Target umfasst als Material Kohlenstoff und das Plasma ein Gemisch aus Wasserstoff und Argon.

Figur 1 zeigt ein Beispiel für den Messaufbau zur Bestimmung der Energie- und Winkelverteilung von gestreuten Teilchen an einer Substratoberfläche. Der Aufbau umfasst eine Quelle für Ionenstrahlen, einen Detektor und ein Substrat. Die Winkel $\alpha$, in welchem die Quelle für Ionenstrahlen ausgerichtet ist und der Winkel $\theta$, in welchem der Detektor ausgerichtet ist, werden relativ zum Normalenvektor auf die Oberfläche beziehungsweise relativ zur Normalen der Oberfläche gemessen und variiert. Der Detektor misst die Energie und die Masse der reflektierten Teilchen.

Figur 2 a) zeigt ein Schema der Labormessungen von Reflektionsvermögen des Spiegels. Die Vorrichtung zur Messung umfasst einen Detektor A, eine Lichtquelle und einen Spiegel. Figur 2 b) zeigt die Anwendung der Spiegeloberfläche bei der Kontrolle des technologischen Prozesses während des Plasmabetriebs. Die Vorrichtung umfasst einen Detektor, ein Plasma, ein Substrat beziehungsweise Target und einen Halter für das Substrat beziehungsweise Target.

Figur 3 zeigt schematisch, wie die Reflektion von schnellen Plasma-Ionen ($H^+$) an der Substratoberfläche zur Produktion von schnellen neutralen Atomen (H) im Plasma führt. Die Ionen werden durch eine Spannung $-U_0$ auf eine Oberfläche beschleunigt und die neutralen Atome werden zurückgestreut. Die höchste Energie der Atome wird für H- oder D-Ionen, also für Wasserstoff- oder Deuterium-Ionen, erreicht.

Figur 4 zeigt schematisch den Effekt der Dopplerverschiebung vor spiegelnden Oberflächen, v ist die Geschwindigkeit des Atoms. Die Vorrichtung zur Bestimmung der Auswirkung des Dopplereffekts umfasst einen Detektor A und einen Spiegel, der gegenüber dem Detektor angeordnet ist. In der oberen Hälfte der Figur wird der Fall des ruhenden Atoms $v = 0$ betrachtet. Die Wellenlänge bei der maximalen Intensität der von dem Atom in diesem Fall emittierten elektromagnetischen Strahlung beziehungsweise des Lichtes wird mit $\lambda_0$ bezeichnet. In dem unteren Teil der Figur wird die Aufspaltung des Spektrums durch die Dopplerverschiebung dargestellt, wenn sich das Atom mit einer endlichen Geschwindigkeit v bewegt. Es prägen sich zwei Maxima der Intensität bei Wellenlängen $\lambda$ aus, die von $\lambda_0$ verschieden sind. Der Teil des Spektrums beziehungsweise der Intensitätsverteilung, welcher von der Strahlung stammt, die an dem Spiegel reflektiert wird, ist schraffiert dargestellt. Diese Strahlung kann auch durch einen zweiten Detektor B gemessen werden, der statt des Spiegels an gleicher Stelle wie dieser verwendet wird. Die Trennung der beiden Linien hängt von der Geschwindigkeit beziehungsweise kinetischen Energie der Atome ab.

Figur 5 zeigt die Beobachtung der reflektierten Deuterium-Atome unter dem Winkel von 35° zur Oberflächennormalen des Wolfram (W)-Substrats. Die verschiedenen Wertekurven entsprechen den verschiedenen Mischverhältnissen zwischen Argon (Ar) und Deuterium (D) in dem Niederdruckplasma. Das angelegte Potential beträgt -140 V. Die blau-verschobene Komponente wird zur Messung der Energie- und Winkelverteilung benutzt. Die rotverschobene Komponente ist ein Ergebnis der spektralen Reflektion (siehe Figur 6).

Figur 5 a) zeigt Wertekurven über den gesamten gemessenen Intensitätsbereich. Figur 5 b) zeigt einen begrenzten Intensitätsbereich, in dem die Maxima durch die Dopplerverschiebung erkennbar sind. Auf der x-Achse ist in Figur 5 a) und Figur 5 b) die Wellenlänge in Å aufgetragen. Auf der y-Achse ist die dimensionslose Intensität aufgetragen. Die Intensität ist für verschiedene Mischungsverhältnisse von Argon und Deuterium aufgetragen. Die Mischungsverhältnisse liegen bei 90:3, 90:7, 90:10, 85:20, 60:40 und 30:80. Die Zuordnung der jeweiligen Intensitätsverteilungen zu den Mischungsverhältnissen kann den Legenden in den Figuren 5 a) und 5 b) entnommen werden.

In der Figur 5 c) werden auf der y-Achse die diesen Mischungsverhältnissen entsprechenden Gasflüsse in Einheiten von Standardkubikzentimetern (1 sscm = $1.66 \cdot 10^{-8}$ m³/s) gezeigt. Auf der x-Achse ist die Nummerierung entsprechend der Nummerierung der Datenkurven in den Figuren 5 a) und 5 b) aufgetragen.

Figur 6 a) zeigt die Rohdaten zur Intensität der Emission von reflektierten D-Atomen an einem Wolfram-Substrat für Ar-D Plasmen in einem Mischungsverhältnis von 1:1 Figur 6 b) zeigt, dass die blau-verschobene Komponente (6557 Å bis 6561 Å) die Energie- und Winkelverteilung der Atome liefert. Die rot-verschobene Komponente (6561 Å bis 6565 Å) liefert das spektrale Reflektionsvermögen der W-Oberfläche. Der Beobachtungswinkel ist 35° relativ zur Oberflächennormalen.

In den Figuren 6 a) und 6 b) ist auf der unteren x-Achse die Wellenlänge in Å aufgetragen. Auf der y-Achse ist die dimensionslose Intensität aufgetragen. Auf der oberen x-Achse ist in Figur 6 b) der Figur die Energie der Dopplerverschiebung in eV aufgetragen. Die Intensitäten werden für verschiedene an die Oberfläche des Targets angelegten Spannungen gezeigt: -40 V, -80 V, -100 V, -170 V, -200 V, -240 V, -280 V. Die Zuordnung der jeweiligen Intensitätsverteilungen für die Figuren 6 a) und 6 b) zu diesen Spannungswerten kann der Legende in der Figur 6 a) entnommen werden.

Figur 7 zeigt den Vergleich der Energieverteilung von Wasserstoffatomen reflektiert an einem Kohlenstoff (C)-, Eisen (Fe)- und Silber (Ag)-Substrat. Das angelegte Potential beträgt - 200 V. Die reflektierten Wasserstoffatome weisen in der Reihenfolge des Kohlenstoff-, Eisen- und Silber-Substrats eine grösser werdende Energie auf, weil die Atommassen der Atome in dem jeweiligen Substrat grösser werden. Der Beobachtungswinkel beziehungsweise Detektorwinkel ist 35° relativ zur Oberflächennormalen.

Auf der x-Achse ist die Wellenlänge in Å aufgetragen. Auf der y-Achse ist die dimensionslose Intensität aufgetragen. Gezeigt wird für ein Kohlenstoff (C)-, Silber (Ag)- und Eisen (Fe)-Substrat beziehungsweise -Target die Differenz der Intensität zwischen dem Fall, dass eine Spannung von -200 V an die Oberfläche des Targets angelegt wird und dem Fall, dass keine Spannung angelegt wird. Die Reinheitsgrade der Targets liegen in allen Fällen bei mehr als 99,9%. Die Zuordnung der jeweiligen Intensitätsverteilungen zu diesen Substraten beziehungsweise Targets kann der Legende in der Figur entnommen werden.

Figur 8 zeigt Rohdaten der Emission von reflektierten D-Atomen an einem W-Substrat für Ar-D Plasmen. Der Detektorwinkel, also der Winkel $\theta$, beträgt 90° relativ zur Oberflächennormalen. Die Messung liefert in situ die Winkelverteilung der reflektierten Atome.

Auf der y-Achse ist für jede Darstellung der Intensitätsverteilung für einen jeweiligen Spannungswert der Abstand von der Oberfläche des Targets in cm aufgetragen. Auf der x-Achse ist für jede solche Darstellung die Wellenlänge abzüglich der Wellenlänge der $\alpha$-Linie der Balmer-Serie von Deuterium von 6561,01 Å in Å aufgetragen. Die Grauabstufungen geben die dimensionslose Intensität wieder, wobei weiß für die höchste Intensität und schwarz für die niedrigste Intensität steht. Die Werte der Spannungen betragen -40 V, -80 V, -100 V, -140 V, -170 V, -200 V, -240 V, -280 V. Die Breite der dopplerverschobenen Bereiche nimmt mit steigender Spannung zu.

Figur 9 zeigt Rohdaten der Intensität der Emission von reflektierten D-Atomen an einem W-Substrat für Ar-D Plasmen nach Integration über den räumlichen Bereich zwischen der Oberfläche und einer Fläche, welche aus der Verschiebung der Oberfläche bis zu einem Abstand von 5 mm in Richtung senkrecht zur Oberfläche hervorgeht. Der Detektorwinkel beträgt $\theta$ = 90° relativ zur Oberflächennormalen.

Auf der x-Achse ist in Figur 9 a) die Wellenlänge in Å aufgetragen. Auf der y-Achse ist die dimensionslose Intensität aufgetragen. Aus Figur 9 b) kann die Winkelverteilung der Wasserstoffteilchen bestimmt werden. Die gemessenen Daten können mit theoretischen Modellen verglichen werden [5]. Auf der x-Achse ist in Figur 9 b) die Energie der Dopplerverschiebung in eV aufgetragen. Auf der y-Achse ist die dimensionslose Intensität aufgetragen.

Die Intensitäten in den Figuren 9 a) und 9 b) werden für verschiedene, an die Oberfläche des Targets angelegten Spannungen gezeigt: -40 V, -80 V, -100 V, -170 V, -200 V, -240 V, -280 V. Die Zuordnung der jeweiligen Intensitätsverteilungen zu diesen Spannungswerten kann der Legende rechts in den Figuren 9 a) und 9 b) entnommen werden. In der Legende links in Figur 9 a) ist der Gasfluss des Argon und Deuterium von jeweils 80 sccm (1.3 $10^{-6}$ m$^3$/s) angegeben.

Figur 10 zeigt die Winkelverteilung der reflektierten Atome, gerechnet für verschiedene Formparameter b. Der Beobachtungswinkel beziehungsweise der Detektorwinkel beträgt $\theta$ = 90° wie in der Figur 9

Auf der x-Achse ist die Differenz der Energie der Dopplerverschiebung und der Energie der Wellenlänge des Lichtes aufgetragen, welches von einem relativ zum Detektor ruhenden Atom emittiert wird, dividiert durch die letztgenannte Energie des Lichtes des ruhenden Atoms. Auf der y-Achse ist die dimensionslose Intensität aufgetragen.

Die Intensitäten werden für verschiedene Formfaktoren gezeigt: b=0,2, b=0,5, b=1,0, b= 2,0 und b=5,0. Die Zuordnung der Intensitätsverteilungen zu den Formfaktoren kann der Legende in der Figur entnommen werden.

Figur 11 zeigt Messungen des spektralen Reflektionsvermögens einer Wolfram (W)-Oberfläche mit einem Argon-Deuterium (Ar-D)-Plasma mit den in der Beschreibung genannten Parametern.

In Figur 11 a) ist auf der x-Achse die Wellenlänge in Å aufgetragen. Auf der y-Achse ist die dimensionslose Intensität aufgetragen. Es wird schematisch das Profil des rot- und blauverschobenen Bereichs des Spektrums gezeigt, wenn die Differenz der Intensität zwischen dem Fall, dass eine endliche negative Spannung an die Oberfläche des Targets angelegt wird und dem Fall, dass keine Spannung angelegt wird, betrachtet wird.

In Figur 11 b) ist auf der x-Achse die Wellenlänge in Å aufgetragen. Auf der y-Achse ist das spektrale Reflektionsvermögen r aufgetragen. Die Werte des spektralen Reflektionsvermögens werden wie folgt berechnet:

a) Integration über den blauverschobenen Bereich der Wertekurve von der Wellenlänge $\lambda_0$ - $\Delta\lambda_{max}$, aus welcher sich gemäß dem Verfahren im Hauptanspruch die Energie $E_{max}$ ergibt, bis zu einer Wellenlänge $\lambda_i$, wobei der Wert $\lambda_i$ kleiner ist als $\lambda_0$ - $\Delta\lambda_{max}$. sin $\theta$ mit der Differenz $\Delta\lambda_{max}$ zwischen der Wellenlänge $\lambda_0$, der Wellenlänge des Lichtes, welches von einem relativ zum Detektor ruhenden Atom emittiert wird, und der Wellenlänge $\lambda_{max}$.
b) Integration über den rotverschobenen Bereich der Wertekurve zwischen einer Wellenlänge $\lambda_i$' bis zu dem Endpunkt $\lambda_0$ + $\Delta\lambda_{max}$ dieses Bereichs, wobei die Wellenlängen $\lambda_i$ und $\lambda_i$' so gewählt werden, dass die beiden Integrationsintervalle gleich lang sind und $\lambda_i$' grösser als $\lambda_0$ + $\Delta\lambda_{max} \cdot$ sin $\theta$ und kleiner als $\lambda_0$ + $\Delta\lambda_{max}$ ist.
c) Bestimmung des spektralen Reflektionsvermögens als das Verhältnis zwischen kleinerem zu größerem Integral.

Die Figur 11 b) zeigt die Werte des spektralen Reflektionsvermögens für verschiedene Wellenlängen $\lambda_i$ und den gemäß dem obigen Verfahren durch die Breite des Integrationsintervalls durch die $\lambda_i$ festgelegten $\lambda_i$'. Mit SRV wird das Signal-Rausch-Verhältnis bezeichnet.

Die Werte des spektralen Reflektionsvermögens werden für verschiedene an die Oberfläche des Targets angelegten Spannungen gezeigt: -280 V, -240 V, -170 V. Die Zuordnung der Werte des spektralen Reflektionsvermögens zu den Spannungen kann der Legende in der Figur 11 b) entnommen werden.

Die grau markierten Minima der Werte des spektralen Reflektionsvermögens zeigen für alle angelegten Spannungen eine gute Übereinstimmung.

Figur 12 zeigt die Differenz der Intensitäten zwischen den beiden Fällen, dass -200 V Spannung und dass keine Spannung an die Oberfläche des Targets angelegt wird. Die Intensität wird in Figur 12 als Anzahl der im Detektor beziehungsweise durch den Detektor gezählten Photoelektronen gemessen. Die Anzahl dieser Photoelektronen ist bekanntermaßen proportional zu der auf den Detektor auftreffenden Photonen. Das Target umfasst als Material Kohlenstoff $C^{12}$ bei einem Reinheitsgrad von 99,99 %. Zur Bestimmung des Oberflächenmaterials wurden Wasserstoffionen in Richtung Oberfläche beschleunigt. Die Rauigkeit liegt bei dem arithmetischen Mittenrauwert Ra=0,4 $\mu$m, die Oberflächentemperatur des Targets bei 150°C. Der Detektor umfasst eine Kamera des Typs Andor DV 8201_BV. Der Detektor ist in einem Meter Abstand von der Oberfläche des Targets mit einem Winkel von 35° relativ zum Normalenvektor auf diese Oberfläche positioniert. Die spektrale Auflösung des Detektors liegt bei 5 pm, die Auflösung hinsichtlich der Dispersion bei 1 pm. Der Gasfluss des dem Plasma zugeführten Argon liegt bei 40 sccm (6.66 $10^{-7}$ m³/s).

Der Gasfluss des dem Plasma zugeführten Wasserstoff liegt ebenfalls bei 40 sccm (6.66 $10^{-7}$ m³/s).

Der Plasmadruck liegt bei 2,5 · $10^{-4}$ mbar (0.025 Pa). Die Integrationszeit beziehungsweise Messzeit liegt bei 300 Sekunden. Die Größe des Targets liegt bei 13 mm x 13 mm. Die Temperatur der Ionen liegt bei 1 eV bis 3 eV, die der Elektronen bei 5 eV bis 10 eV. Die Stelle der Wertekurve, bei welcher die Energie $E_{max}$ liegt, ist mit einem schwarzen Pfeil markiert.

Die Tabelle 1 zeigt die Intensitätsdifferenzen, welche aus Rohdaten dieser Messung gewonnen werden, wobei die Energie in Elektronenvolt angegeben ist und die Intensität dimensionslos ist. Der Wert von $E_{max}$ ergibt sich zu $E_{max}$ = -137,96 eV bei einer Intensitätsdifferenz von I = 15548. Aus der in Anspruch 1 in Schritt h) genannten Formel ergibt sich mit der Masse von Kohlenstoff für $m_2$, dass der Wert von $E_{max}$ bei $E_{max}$ = 145,55 eV liegt. Dies entspricht einer relativen Abweichung von 5 %, wenn die Absolutwerte der Energiewerte betrachtet werden. Damit lässt sich der Wert von $E_{max}$ dem Element Kohlenstoff zuordnen. Tabelle 1: Differenz der Intensität, wenn -200 V Spannung und keine Spannung an die Oberfläche eines Targets umfassend Kohlenstoff angelegt wird und das Plasma ein Gemisch aus Wasserstoff und Argon im Mischungsverhältnis 1:1 umfasst.

| Energie | Intensität | Energie | Intensität | Energie | Intensität |
|---|---|---|---|---|---|
| -240,8182822 | 15324 | -200,5459967 | 15195 | -163,9560364 | 15280 |
| -239,7922202 | 15292 | -199,6097475 | 15196 | -163,1096001 | 15236 |
| -238,7683488 | 15309 | -198,6756889 | 15297 | -162,2653543 | 15364 |
| -237,7466679 | 15221 | -197,7438208 | 15227 | -161,423299 | 15277 |
| -236,7271776 | 15271 | -196,8141433 | 15237 | -160,5834343 | 15349 |
| -235,7098778 | 15381 | -195,8866563 | 15324 | -159,7457602 | 15158 |
| -234,6947686 | 15318 | -194,9613599 | 15333 | -158,9102766 | 15327 |
| -233,6818499 | 15201 | -194,0382541 | 15267 | -158,0769835 | 15331 |
| -232,6711218 | 15277 | -193,1173388 | 15309 | -157,2458811 | 15340 |
| -231,6625843 | 15048 | -192,1986141 | 15288 | -156,4169692 | 15284 |
| -230,6562373 | 15229 | -191,2820799 | 15363 | -155,5902478 | 15271 |
| -229,6520809 | 15249 | -190,3677363 | 15070 | -154,765717 | 15386 |
| -228,650115 | 15204 | -189,4555832 | 15154 | -153,9433767 | 15440 |
| -227,6503397 | 15241 | -188,5456207 | 15127 | -153,123227 | 15278 |
| -226,6527549 | 15244 | -187,6378487 | 15159 | -152,3052679 | 15446 |
| -225,6573607 | 15192 | -186,7322673 | 15323 | -151,4894993 | 15443 |
| -224,664157 | 15372 | -185,8288765 | 15213 | -150,6759213 | 15442 |
| -223,673144 | 15419 | -184,9276762 | 15216 | -149,8645338 | 15461 |
| -222,6843214 | 15086 | -184,0286665 | 15298 | -149,0553369 | 15314 |
| -221,6976894 | 15169 | -183,1318473 | 15239 | -148,2483306 | 15374 |
| -220,713248 | 15276 | -182,2372187 | 15349 | -147,4435148 | 15305 |
| -219,7309972 | 15060 | -181,3447807 | 15073 | -146,6408895 | 15424 |

(fortgesetzt)

| Energie | Intensität | Energie | Intensität | Energie | Intensität |
|---|---|---|---|---|---|
| -218,7509368 | 15253 | -180,4545332 | 15346 | -145,8404549 | 15516 |
| -217,7730671 | 14997 | -179,5664762 | 15166 | -145,0422107 | 15393 |
| -216,7973879 | 15285 | -178,6806099 | 15131 | -144,2461572 | 15395 |
| -215,8238992 | 15215 | -177,796934 | 15272 | -143,4522941 | 15302 |
| -214,8526012 | 15210 | -176,9154488 | 14987 | -142,6606217 | 15430 |
| -213,8834936 | 15254 | -176,036154 | 15192 | -141,8711398 | 15376 |
| -212,9165767 | 15168 | -175,1590499 | 15246 | -141,0838484 | 15352 |
| -211,9518502 | 15099 | -174,2841363 | 15257 | -140,2987476 | 15418 |
| -210,9893144 | 15205 | -173,4114132 | 15319 | -139,5158374 | 15242 |
| -210,0289691 | 15242 | -172,5408807 | 15313 | -138,7351177 | 15392 |
| -209,0708143 | 15219 | -171,6725388 | 15220 | -137,9565886 | 15548 |
| -208,1148501 | 15124 | -170,8063874 | 15208 | -137,18025 | 15469 |
| -207,1610765 | 15117 | -169,9424266 | 15238 | -136,406102 | 15691 |
| -206,2094934 | 15227 | -169,0806563 | 15278 | -135,6341446 | 15397 |
| -205,2601009 | 15230 | -168,2210766 | 15241 | -134,8643777 | 15651 |
| -204,312899 | 15137 | -167,3636875 | 15287 | -134,0968013 | 15783 |
| -203,3678875 | 15299 | -166,5084889 | 15207 | | |
| -202,4250667 | 15276 | -165,6554809 | 15351 | | |
| -201,4844364 | 15212 | -164,8046634 | 15171 | | |

In dieser Anmeldung zitierte Literatur

[1] Andersen HH. et al., Nucl. Instrum. and Meth. in Phys. Res. B 6 459 (1985)

[2] Feder R. et al., Nucl. Instrum. and Meth. in Phys. Res. B 316 198 (2013)

[3] Cooksey C., Nadal M., Allen DW, Hauer KO, Höpe A, Applied Optics 54 4006 (2015).

[4] Howell JR, Siegel R and Mengüc MP, "Thermal Radiation Heat Transfer", CRC Press, Taylor and Francis Group LCC, p. 70 (2011)

[5] TRIM/SRIM Code: *Stopping and Range of Ions in Matter,* http://www.srim.org

[6] Alfold TL, Feldman LC, Mayer JW, Fundamentals of Nanoscale Film Analysis, Springer, Berlin (2007) ISBN: 978-0-387-29260-1

[7] Babkina T. et al, Europhys. Letters 72 235 (2005)

[8] Adamov M.R.G., Obradovic B.M., Kuraica M.M., Konjevic N., *IEEE Trans. Plasma. Sci.* **31**, 444 (2003); Adamov M.G., Kuraica M.M., Konjevic N., *Eur. Phys. J. D* **28***, 393* (2004).

[9] Phelps A.V., Phys. Rev. E 79 066401 (2009)

[10] Brandt C. et al, O3.J107, 42nd European Physical Society Conference on Plasma Physics, Lisbon (2015).

[11] Kreter et al, Fusion Sci. Technol. 68 8 (2015)

[12] WEB-Link: www.refractiveindex.info

**Patentansprüche**

**1.** Verfahren zur in situ Bestimmung der Oberflächeneigenschaften von leitfähigen Targets im Vakuum, umfassend die folgenden Schritte:

a) Erzeugung eines Niederdruckplasmas vor der Oberfläche des Targets
b) Anlegen einer Spannung an die Oberfläche des Targets

c) Ausrichtung mindestens eines lichtempfindlichen Detektors mit einem Winkel $\theta$ relativ zur Senkrechten der Oberfläche des Targets

d) Messung der Intensität des Lichtes, welches von den elektrisch neutralen Atomen emittiert wird, die durch Umwandlung aus den Ionen erzeugt werden, welche aus dem Niederdruckplasma durch die angelegte Spannung in Richtung der Oberfläche des Targets beschleunigt und anschließend an dieser reflektiert werden und dabei mit der Oberfläche zur Erlangung der elektrischen Neutralität geeignete Ladungen austauschen

e) Messung von Spektrallinien aus der Balmer-Serie der Atome, die von der Oberfläche des Targets reflektiert werden, und Dopplerverschiebungen dieser Spektrallinien zur Ermittlung einer Wertekurve umfassend die Wellenlängen und die zu jeder Wellenlänge zugehörige Intensität des Lichtes, welche durch Dopplerverschiebungen einen blauverschobenen Wellenlängenbereich mit kleineren Wellenlängen als die Wellenlänge $\lambda_0$ des Lichtes, welches von Atomen emittiert wird, die relativ zum Detektor ruhen, umfasst und solche, die einen rotverschobenen Bereich mit Wellenlängen größer als $\lambda_0$ umfasst

f) Bestimmung der Geschwindigkeit $v$ der Atome, welche Licht mit einer Wellenlänge A aus der Wertekurve emittieren, gemäß $v = \frac{\lambda}{\lambda - \lambda_0} \cdot c$ , wobei $c$ die Lichtgeschwindigkeit bezeichnet, und daraus der jeweiligen kinetischen Energie $E$ der Atome gemäß $E = \frac{1}{2}m_1 v^2$ , wobei $m_1$ die jeweilige Masse der reflektierten Atome bezeichnet

g) Bestimmung des Energiewertes $E_{max}$ als der kleinsten aus den gemessenen Wellenlängen bestimmten Energie, ab der alle Werte der Intensität der Wertekurve größer oder gleich sind wie die Intensitätswerte der Grundlinie des Detektorsignals

h) Ermittlung der Masse $m_2$ der Atome der Oberfläche durch die Formel:

$$E_{max} = \left[ \frac{(m_2^2 - m_1^2 \sin^2 \theta)^{1/2} - m_1 \cdot \cos \theta}{m_1 + m_2} \right]^2 \cdot E_0,$$

wobei $E_0$ die jeweilige kinetische Energie der Ionen beim Auftreffen auf die Oberfläche bezeichnet, welche gleich dem Absolutwert der angelegten Spannung ist, und $\theta$ den Winkel relativ zum Normalenvektor der Oberfläche des Targets beziehungsweise zur Senkrechten auf die Oberfläche des Targets bezeichnet.

2. Verfahren nach Anspruch 1,
**dadurch gekennzeichnet, dass** die Intensitätswerte der Wertekurve, welche bei einer angelegten Spannung von Null Volt ermittelt wird, von den Intensitätswerten einer bei einer von Null Volt verschiedenen Spannung ermittelten Wertekurve subtrahiert werden.

3. Verfahren nach einem der Ansprüche 1 bis 2,
**dadurch gekennzeichnet, dass** der maximale Intensitätswert $\tilde{I}$ aus dem blau- und rotverschobenen Wellenlängenbereich der in Schritt e) in Anspruch 1 bestimmten Wertekurve bestimmt wird sowie die diesem Intensitätswert gemäß der Wertekurve zugehörige Wellenlänge X, danach die Differenz $\Delta\lambda = \lambda_0 - \tilde{\lambda}$, zwischen der Wellenlänge $\lambda_0$ und der Wellenlänge $\tilde{\lambda}$ berechnet wird, dann die Intensität $I_1$ bei $\lambda_0 + \Delta\lambda$ bestimmt wird und danach das spektrale Reflektionsvermögen bezüglich der spekularen Reflektion $r_S$ gemäß $r_S = \frac{I_1}{\tilde{I}}$ berechnet wird.

4. Verfahren nach einem der vorigen Ansprüche, **gekennzeichnet durch**

a) Ermittlung des Wertes der maximalen Intensität in dem Wellenlängenbereich zwischen der Wellenlänge $\lambda_0$ - $\Delta\lambda_{max}$ und der Wellenlänge $\lambda_0 - \Delta\lambda_{max} \sin(\theta)$.
b) Ermittlung des Wertes der maximalen Intensität in dem Wellenlängenbereich zwischen der Wellenlänge $\lambda_0$ + $\Delta\lambda_{max} \sin(\theta)$ und der Wellenlänge $\lambda_0 + \Delta\lambda_{max}$.
c) Ermittlung des spektralen Reflektionsvermögens durch Division des kleineren Wertes der Intensität durch den größeren Wert der Intensität, welche in den Schritten a) und b) ermittelt wurden.

5. Verfahren nach einem der Ansprüche 1 bis 4,
**dadurch gekennzeichnet, dass** aus einer Schar von Wertekurven, bei der jede Wertekurve bei einem unterschied-

lichen Winkel $\theta$ in einem Bereich von 0° bis 90° gemessen wurde, die Wertekurve mit der höchsten Intensität ausgewählt wird.

6. Verfahren nach einem der Ansprüche 1 bis 5,
   **dadurch gekennzeichnet, dass** zur Ermittlung des Winkels $\theta$ mit der höchsten maximalen Intensität des Lichts die Wertekurve bei einem Winkel zwischen Detektor und dem Normalenvektor senkrecht auf die Oberfläche des Targets von $\theta$ =90° bestimmt wird.

7. Verfahren nach Anspruch 6,
   **dadurch gekennzeichnet, dass** die Winkelverteilung der Atome nach der Reflektion an der Oberfläche durch eine Anpassung von aus einem TRIM oder SRIM Code bestimmten Wertekurven an die bei einem Winkel $\theta$, insbesondere einem Winkel $\theta$ = 90°, gemessenen Wertekurve bestimmt wird, wobei die Anpassung insbesondere mit der Methode der kleinsten Quadrate erfolgt.

8. Verfahren nach Anspruch 6 oder 7,
   **dadurch gekennzeichnet, dass** die Winkelverteilung der Atome nach der Reflektion an einer planaren Oberfläche eines Targets bestimmt wird, indem aus einer Schar von Wertekurven, welche ein Profil gemäß der Formel $cos^b(\theta)$ mit einem Winkel $\theta$ relativ zur Senkrechten der Oberfläche des Targets und einem Formparameter b aufweisen, diejenige bestimmt wird, welche gemäß der Methode der kleinsten Quadrate am besten mit der bei einem Winkel $\theta$, insbesondere einem Winkel $\theta$ =90°, gemessenen Wertekurve übereinstimmt.

9. Verfahren nach einem der Ansprüche 1 bis 8,
   **dadurch gekennzeichnet, dass** an die Oberfläche des Targets eine Spannung von -500 V bis 0 V angelegt wird.

10. Verfahren nach einem der Ansprüche 1 bis 9,
    **dadurch gekennzeichnet, dass** der Druck im Niederdruckplasma 0,01 Pa bis 0,1 Pa beträgt.

11. Verfahren nach einem der Ansprüche 1 bis 10,
    **dadurch gekennzeichnet, dass** das Plasma Argon oder Wasserstoff oder Deuterium oder Mischungen dieser Elemente umfasst.

12. Verfahren nach einem der Ansprüche 1 bis 11,
    **dadurch gekennzeichnet, dass** zur Ermittlung der Wertekurve Spektrallinien aus der Balmer-Serie der Atome Wasserstoff und Deuterium und Dopplerverschiebungen dieser Spektrallinien gemessen werden.

13. Verfahren nach einem der Ansprüche 1 bis 12,
    **dadurch gekennzeichnet, dass** das Plasma Mischungen von Argon oder Krypton oder Wasserstoff oder Deuterium, insbesondere im Mischungsverhältnis Ar:H=1:1 oder Ar:D=1:1, umfasst.

14. Verfahren nach einem der Ansprüche 1 bis 13,
    **dadurch gekennzeichnet, dass** das Target Atome der Elemente Kohlenstoff oder Aluminium umfasst.

15. Verfahren nach einem der Ansprüche 1 bis 14,
    **dadurch gekennzeichnet, dass** das Target einen Reinheitsgrad von 95 % bis 100 %, und insbesondere von 99,94 % bis 99,999 % aufweist.


**Claims**

1. A method for in-situ determination of the surface characteristics of conductive targets under vacuum, comprising the steps of:

   a) generating a low-pressure plasma in front of the surface of the target
   b) applying a voltage to the surface of the target
   c) orientating at least one light-sensitive detector at an angle $\theta$ relative to the perpendicular of the surface of the target
   d) measuring the intensity of the light emitted by the electrically neutral atoms generated by conversion from the ions which are accelerated out of the low-pressure plasma by the applied voltage towards the surface of the target and subsequently reflected thereon, and which thus exchange suitable charges with the surface to reach electrical neutrality

e) measuring spectral lines from the Balmer series of the atoms reflected by the surface of the target, and Doppler shifts of these spectral lines to establish a value curve, comprising the wavelengths and the intensity of the light associated with each wavelength, which, as a result of Doppler shifts, comprises a blue-shifted wavelength range with smaller wavelengths than the wavelength $\lambda_0$ of the light emitted by atoms stationary relative to the detector, and such, comprising a red-shifted range with wavelengths greater than $\lambda_0$

f) determining the velocity v of the atoms which emit light of a wavelength $\lambda$ from the value curve according to

$$v = \frac{\lambda}{\lambda - \lambda_0} \cdot c$$

, where c denotes the speed of light, and therefrom, the respective kinetic energy E of the atoms according to $E = \frac{1}{2} m_1 v^2$ , where $m_1$ denotes the respective mass of the reflected atoms

g) determining the energy value $E_{max}$ as the smallest energy determined from the measured wavelengths, from which all values of the intensity of the value curve are greater than or equal to the intensity values of the base line of the detector signal

h) establishing the mass $m_2$ of the atoms of the surface using the formula:

$$E_{max} = \left[ \frac{(m_2^2 - m_1^2 \sin^2\theta)^{1/2} - m_1 \cdot \cos\theta}{m_1 + m_2} \right]^2 \cdot E_0 \,,$$

where $E_0$ denotes the respective kinetic energy of the ions when impinging on the surface, which is equal to the absolute value of the applied voltage, and θ denotes the angle relative to the normal vector of the surface of the target or to the perpendicular of the surface of the target.

2. The method according to claim 1,
**characterised in that** the intensity values of the value curve established at an applied voltage of zero volts are subtracted from the intensity values of a value curve established at a voltage other than zero volts.

3. The method according to any one of claims 1 to 2,
**characterised in that** the maximum intensity value $\tilde{I}$ is determined from the blue- and red-shifted wavelength ranges of the value curve determined in step e) of claim 1, as well as the wavelength $\tilde{\lambda}$ associated with this intensity value according to the value curve, subsequently the difference $\Delta\lambda = \lambda_0 - \tilde{\lambda}$ between the wavelength $\lambda_0$ and the wavelength $\tilde{\lambda}$ is calculated, then the intensity $I_1$ at $\lambda_0 + \Delta\lambda$ is determined, and subsequently the spectral reflectivity in relation to the specular reflection $r_s$ is calculated according to $r_s = \frac{I_1}{\tilde{I}}$ .

4. The method according to any one of the previous claims, **characterised by**

a) establishing the value of the maximum intensity in the wavelength range between the wavelength $\lambda_0 - \Delta\lambda_{max}$ and the wavelength $\lambda_0 - \Delta\lambda_{max}\sin(\theta)$.
b) establishing the value of the maximum intensity in the wavelength range between the wavelength $\lambda_0 + \Delta\lambda_{max}\sin(\theta)$ and the wavelength $\lambda_0 + \Delta\lambda_{max}$.
c) establishing the spectral reflectivity by dividing the smaller value of the intensity by the larger value of the intensity established in steps a) and b).

5. The method according to any one of claims 1 to 4,
**characterised in that**, from a set of value curves, in which each value curve was measured at a different angle $\theta$ in a range of 0° to 90°, the value curve having the highest intensity is selected.

6. The method according to any one of claims 1 to 5,
**characterised in that**, to establish the angle $\theta$ having the highest maximum intensity of the light, the value curve is determined at an angle of $\theta = 90$° btween the detector and the normal vector perpendicular to the surface of the target.

**7.** The method according to claim 6,
**characterised in that** the angular distribution of the atoms upon reflection on the surface is determined by adaptation of value curves determined from a TRIM or SRIM code to the value curve measured at an angle $\theta$, in particular an angle of $\theta = 90°$, the adaptation being accomplished in particular by the least-squares method.

**8.** The method according to claim 6 or 7,
**characterised in that** the angular distribution of the atoms upon reflection on a planar surface of a target is determined by determining, from a set of value curves having a profile according to the formula $cos^b(\theta)$ with an angle $\theta$ relative to the perpendicular of the surface of the target and a shape parameter b, the one which, according to the least-squares methods, best matches the value curve measured at an angle $\theta$, in particular an angle of $\theta = 90°$.

**9.** The method according to any one of claims 1 to 8,
**characterised in that** a voltage of -500 V to 0 V is applied to the surface of the target.

**10.** The method according to any one of claims 1 to 9,
**characterised in that** the pressure in the low-pressure plasma is 0.01 Pa to 0.1 Pa.

**11.** The method according to any one of claims 1 to 10,
**characterised in that** the plasma comprises argon or hydrogen or deuterium or mixtures of these elements.

**12.** The method according to any one of claims 1 to 11,
**characterised in that**, to establish the value curve, spectral lines from the Balmer series of the atoms hydrogen and deuterium and Doppler shifts of these spectral lines are measured.

**13.** The method according to any one of claims 1 to 12,
**characterised in that** the plasma comprises mixtures of argon or krypton or hydrogen or deuterium, in particular in the mixing ratio of Ar:H = 1:1 or Ar:D = 1:1.

**14.** The method according to any one of claims 1 to 13,
**characterised in that** the target comprises atoms of the elements carbon or aluminium.

**15.** The method according to any one of claims 1 to 14,
**characterised in that** the target has a degree of purity of 95% to 100%, and in particular of 99.94% to 99.9999%.

**Revendications**

**1.** Procédé de détermination in situ des propriétés de surface de cibles conductrices dans le vide, comprenant les stades suivants :

a) production d'un plasma à basse pression devant la surface de la cible,
b) application d'une tension à la surface de la cible,
c) orientation d'au moins un détecteur sensible à la lumière suivant un angle θ par rapport à la perpendiculaire de la surface de la cible,
d) mesure de l'intensité de la lumière, qui est émise par les atomes neutres électriquement, qui sont produits par transformation des ions, qui, par la tension appliquée, sont accélérés du plasma à basse pression en direction de la surface de la cible et y sont ensuite réfléchis et échangent ainsi avec la surface des charges appropriées à l'obtention de la neutralité électrique,
e) mesure de raies spectrales de la série de Balmer des atomes, qui sont réfléchis par la surface de la cible, et déplacements Doppler de ces raies spectrales pour l'émission d'une courbe de valeurs comprenant les longueurs d'onde et l'intensité, appartenant à chaque longeur d'onde, de la lumière, qui comprend, par des déplacements Doppler, un domaine de longueur d'onde décalé vers le bleu ayant des longueurs d'onde plus petites que la longueur d'onde $\lambda_0$ de la lumière, qui est émise par des atomes, qui sont au repos par rapport au détecteur, et celle qui comprend un domaine décalé vers le rouge, ayant des longueurs d'onde plus grande que $\lambda_0$,
f) détermination de la vitesse v des atomes, qui émettent, à partir de la courbe de valeurs, de la lumière ayant une longueur d'onde λ suivant $v = \frac{\lambda}{\lambda - \lambda_0} \cdot c$ dans laquelle $c$ désigne la vitesse de la lumière et de là l'énergie E cinétique respective des atomes suivant $E = \frac{1}{2} m_1 v^2$ , dans laquelle $m_1$ désigne la masse respective des atomes réfléchis,

g) détermination de la valeur $E_{max}$ de l'énergie comme l'énergie la plus petite déterminée à partir des longueurs d'onde mesurées, à partir de laquelle toutes les valeurs de l'intensité de la courbe de valeurs sont supérieures ou égales aux valeurs d'intensité de la ligne de base du signal du détecteur,

h) détermination de la masse $m_2$ des atomes de la surface par la formule :

$$E_{max} = \left[ \frac{(m_2^2 - m_1^2 \sin^2 \theta)^{1/2} - m_1 \cdot \cos \theta}{m_1 + m_2} \right]^2 \cdot E_0,$$

dans laquelle $E_0$ désigne l'énergie cinétique respective des ions, lorsqu'ils arrivent sur la surface, qui est égale à la valeur absolue de la tension appliquée, et θ désigne l'angle par rapport au vecteur normal de la surface de la cible et respectivement par rapport à la perpendiculaire à la surface de la cible.

2. Procédé suivant la revendication 1, **caractérisé en ce que** l'on soustrait les valeurs d'intensité de la courbe de valeurs, qui est émise pour une tension appliquée de zéro volt, des valeurs d'intensité d'une courbe de valeurs émise pour une tension différente de zéro volt.

3. Procédé suivant l'une des revendications 1 à 2, **caractérisé en ce que** l'on détermine la valeur $\tilde{I}$ maximum de l'intensité dans le domaine de longueurs d'onde décalé vers le bleu et le rouge de la courbe de valeurs déterminée au stade e) de la revendication 1, ainsi que la longueur d'onde $\tilde{\lambda}$ appartenant, suivant la courbe de valeurs, à cette valeur d'intensité, on calcule ensuite la différence $\Delta\lambda = \lambda_0 - \tilde{\lambda}$ entre la longueur d'onde entre λ et $\tilde{\lambda}$, puis on détermine l'intensité $I_1$ à $\lambda_0 + \Delta\lambda$ et on calcule ensuite le pouvoir spectral réflecteur en ce qui concerne la réflexion $r_s$ spéculaire suivant $r_s = \frac{I_1}{\tilde{I}}$ .

4. Procédé suivant l'une des revendications précédentes, **caractérisé par**

a) détermination de la valeur de l'intensité maximum dans le domaine de longueur d'onde compris entre la longueur d'onde $\lambda_0 - \Delta\lambda_{max}$ et la longueur d'onde $\lambda_0 - \Delta\lambda_{max} \sin(\theta)$,
b) détermination de l'intensité maximum dans le domaine de longueur d'onde compris entre la longueur d'onde $\lambda_0 - \Delta\lambda_{max} \sin(\theta)$ et la longueur d'onde $\lambda_0 - \Delta\lambda_{max}$,
c) détermination du pouvoir réflecteur spectral par division de la valeur la plus petite de l'intensité par la valeur la plus grande de l'intensité, qui ont été déterminées dans les stades a) et b).

5. Procédé suivant l'une des revendications 1 à 4, **caractérisé en ce que** dans une famille de courbes de valeurs, dans laquelle chaque courbe de valeurs a été mesurée à un angle θ différent dans une plage de 0° à 90°, on choisit la courbe de valeurs ayant l'intensité la plus grande.

6. Procédé suivant l'une des revendications 1 à 5, **caractérisé en ce que**, pour la détermination de l'angle θ ayant l'intensité maximum la plus grande de la lumière, on détermine la courbe de valeurs pour un angle entre le détecteur et le vecteur normal perpendiculaire à la surface de la cible de θ = 90°.

7. Procédé suivant la revendication 6, **caractérisé en ce que** l'on détermine la répartition angulaire des atomes après la réflexion sur la surface par un ajustement de courbes de valeurs, déterminées à partir d'un code TRIM ou SRIM, à la courbe de valeurs mesurée à un angle θ, en particulier à un angle θ = 90°, l'ajustement s'effectuant, en particulier, par le procédé des moindres carrés.

8. Procédé suivant la revendication 6 ou 7, **caractérisé en ce que** l'on détermine la répartition angulaire des atomes après la réflexion sur une surface plane d'une cible en déterminant dans une famille de courbes de valeurs, qui ont un profil suivant la formule $\cos^b(\theta)$ ayant un angle $\theta$ par rapport à la perpendiculaire à la surface de la cible et un paramètre de forme b, celle qui, suivant le procédé des moindres carrés, coïncide au mieux avec la courbe de valeurs mesurée pour un angle $\theta$, en particulier un angle $\theta = 90°$.

9. Procédé suivant l'une des revendications 1 à 8, **caractérisé en ce que** l'on applique, à la surface de la cible, une tension de -500 V à 0 V.

10. Procédé suivant l'une des revendications 1 à 9, **caractérisé en ce que** la pression dans le plasma à basse pression va de 0,01 Pa à 0,1 Pa.

11. Procédé suivant l'une des revendications 1 à 10, **caractérisé en ce que** le plasma comprend de l'argon ou de l'hydrogène ou du deutérium ou des mélanges de ces éléments.

12. Procédé suivant l'une des revendications 1 à 11, **caractérisé en ce que**, pour la détermination de la courbe de valeurs, on mesure des raies spectrales de la série de Balmer des atomes d'hydrogène et de deutérium et des déplacements Doppler de ces raies spectrales.

13. Procédé suivant l'une des revendications 1 à 12, **caractérisé en ce que** le plasma comprend des mélanges d'argon ou de crypton ou d'hydrogène ou de deutérium, en particulier dans le rapport de mélange Ar : H = 1 : 1 ou Ar : D = 1 : 1.

14. Procédé suivant l'une des revendications 1 à 13, **caractérisé en ce que** la cible comprend des atomes, des éléments carbone ou aluminium.

15. Procédé suivant l'une des revendications 1 à 14, **caractérisé en ce que** la cible a un degré de pureté de 95 % à 100 %, et, en particulier, de 99,94 % et 99,999 %.

Ionenstrahl

Detektor

θ

α

Substrat

**Figur 1**

a)

Detektor A

Substrat/
Spiegel

Lichtquelle

b)

Technologisches
Laborplasma

Substrat/
Spiegel

Halter

Detektor B

## Figur 2

Potenzial U

$+$

$H^+$

Substrat/
Spiegel

X

H

$U_0$

$-$

## Figur 3

**Figur 4**

Figur 5 a)

Figur 5 c)

**Figur 5 b)**

**Figur 6 a)**

Figur 6 b)

**Figur 7**

**Figur 8**

**Figur 9**

**Figur 10**

a)

Emission der Atomen

Reflexion

$\lambda_0 - \Delta\lambda_{max}$    $\lambda_i$    $\lambda_0 - \Delta\lambda_{max} \sin(\theta)$    $\lambda_0 + \Delta\lambda_{max} \sin(\theta)$    $\lambda_i$    $\lambda_0 + \Delta\lambda_{max}$

x

b) W

| | |
|---|---|
| U=-280 V | ■ |
| U=-240 V | ●·· |
| U=-170 V | ■·· |

niedriges SRV          hohes SRV          niedriges SRV

6557.8   6558   6558.2   6558.4   6558.6   6558.8   6559   6559.2   6559.4

x

**Figur 11**

**Figur 12**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **ANDERSEN HH et al.** *Nucl. Instrum. and Meth. in Phys. Res. B,* 1985, vol. 6, 459
- **FEDER R. et al.** *Nucl. Instrum. and Meth. in Phys. Res. B,* 2013, vol. 316, 198
- **COOKSEY C. ; NADAL M. ; ALLEN DW ; HAUER KO ; HÖPE A.** *Applied Optics,* 2015, vol. 54, 4006
- **HOWELL JR ; SIEGEL R ; MENGÜC MP.** Thermal Radiation Heat Transfer. CRC Press, Taylor and Francis Group LCC, 2011, 70
- **ALFOLD TL ; FELDMAN LC ; MAYER JW.** Fundamentals of Nanoscale Film Analysis. Springer
- **BABKINA T. et al.** *Europhys. Letters,* 2005, vol. 72, 235
- **PHELPS A.V.** *Phys. Rev. E,* 2009, vol. 79, 066401
- **BRANDT C. et al.** *O3.J107, 42nd European Physical Society Conference on Plasma Physics, Lisbon,* 2015
- **KRETER et al.** *Fusion Sci. Technol.,* 2015, vol. 68, 8